# EUROPEAN PATENT APPLICATION

(11) **EP 2 315 259 A1**
(43) Date of publication of application: **27.04.2011**
(21) Application number: 09794473.0
(22) Date of filing: 08.07.2009
(51) Int. Cl.: H01L 31/04, B32B 9/00, B32B 27/30, B32B 27/36

(54) **SOLAR CELL BACKSHEET**

(30) Priority: 11.07.2008 JP 2008181232
(71) Applicant: Mitsubishi Plastics, Inc., Tokyo 103-0021 (JP)
(72) Inventor: OKAWARA, Chiharu, Ushiku-shi Ibaraki 300-1201 (JP); YOSHIDA, Shigenobu, Ushiku-shi Ibaraki 300-1201 (JP); YAMAZAKI, Yoshihiro, Ushiku-shi Ibaraki 300-1201 (JP)
(74) Representative: Gille Hrabal Struck Neidlein Prop Roos
(86) International application number: PCT/JP2009/062455
(87) International publication number: WO 2010/005029

(57) **Abstract**

Provided is a back sheet for a solar battery which holds an excellent gas barriering property and which is excellent in a weatherability and a light shielding property.

It is a back sheet for a solar battery comprising a light shielding colored layer and a weather resistant polyester base resin layer and comprising a gas barriering layer containing a weather resistant coating layer and an inorganic thin film layer provided between the above layers, wherein the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

## Description

### TECHNICAL FIELD

The present invention relates to a back sheet for a solar battery constituting a solar battery module, specifically to a back sheet for a solar battery which holds an excellent gas barriering property and which is excellent in a weatherability and a light shielding property.

### Background Art

In general, a solar battery module has a constitution in which a transparent front substrate, a filler, a solar battery device, a filler and a back sheet are laminated in this order from a light receiving face side. In this connection, the term of a filler includes "a sealing material" which is used as a synonym thereof, but in the present application, hereinafter it shall be described as "a filler' in all cases.
A durability is required to a back sheet for a solar battery in terms of a weatherability, a hydrolytic resistance, a gas barriering property, a mechanical strength, an adhesive property and the like in order to protect a solar battery device when set outdoor for a long time.
On the other hand, while a crystalline silicon base, a polycrystalline silicon base, an amorphous silicon base and the like are used for a solar battery device, a thin film crystal base, an amorphous silicon base, a compound semiconductor base, an organic thin film base, a dye sensitizing base and the like are researched and developed as next generation solar batteries at present, and the various physical properties described above are further highly required to back sheets thereof. Among them, the weatherability, the hydrolytic resistance and the gas barriering property are listed as particularly important items.

A sheet obtained by laminating a fluorine film and a gas barriering film as a weather resistant film has so far been described as a back sheet for a solar battery in a patent document 1, and the problems that the fluorine film has a low mechanical strength and is expensive and that a supply amount thereof is small have been involved therein.
Further, laminates of a white resin film, a gas barriering film and a hydrolysis resistant film are disclosed in a patent document 2 and a patent document 3. In the laminate of the patent document 2, however, the gas barriering film is prepared by merely adhering a metal oxide onto a substrate film. Further, it is described in the patent document 3 that a surface treated layer may be formed on the substrate film in order to enhance an adhesive property thereof with the gas barriering layer in the gas barriering film. This is the same as a publicly known form of a gas barriering film for general packaging, and a back sheet as a constituent material for a solar battery module is not provided with a weatherability and a durability.

On the other hand, it is investigated in a gas barriering film to enhance an adhesive property of an inorganic thin film by subjecting a substrate film to coating treatment in order to inhibit a reduction of a gas barriering property which is brought about by peeling of the inorganic thin film from the substrate film and loss thereof. For example, a coat of a cross-linking reaction product of polyester and isocyanate is disclosed in a patent document 4, but in the coat of the cross-linking reaction product of polyester and isocyanate, an ester group thereof is hydrolyzed under high temperature and high humidity in which a solar battery module is installed, and an adhesive property thereof is notably reduced, which results in a reduction in a gas barriering property. Accordingly, it has not been satisfactory.
Further, an acryl urethane resin is disclosed as an anchor coat layer for a moisture proof film of a back cover material for a solar battery in a patent document 5, but the problem that it is deteriorated under high temperature and high humidity and that an adhesive property thereof can not be held has been involved therein as is the case with the polyester.

Patent document 1: Japanese Patent Application Laid-Open No. 174296/2000
Patent document 2: Japanese Patent Application Laid-Open No. 100788/2002
Patent document 3: Japanese Patent Application Laid-Open No. 150084/2007
Patent document 4: Japanese Patent Publication 22976/1994
Patent document 5: Japanese Patent Application Laid-Open No. 26343/2002

### SUMMARY OF THE INVENTION

### PROBLEMS TO BE SOLVED BY THE INVENTION

In light of the problems described above, the present invention provides a back sheet for a solar battery which holds an excellent gas barriering property and which is excellent in a weatherability and a light shielding property.

### MEANS FOR SOLVING THE PROBLEM

That is, the present invention relates to a back sheet for a solar battery comprising a light shielding colored layer and a weather resistant polyester base resin layer and comprising a gas barriering layer containing a weather resistant coating layer and an inorganic thin film layer provided between the above layers, wherein the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

### ADVANTAGES OF THE INVENTION

A back sheet for a solar battery which holds an excellent gas barriering property and which is excellent in a weatherability and a light shielding property is obtained according to the present invention.

### MODE FOR CARRYING OUT THE INVENTION

The present invention shall be explained below in detail.

### <Light shielding colored layer>

### Base material for light shielding colored layer:

A resin constituting the base material for the light shielding colored layer includes usually, for example, polyethylene base resins, polypropylene base resins, cyclic polyolefin base resins, polystyrene base resins, acrylonitrile-styrene copolymers (AS resins), acrylonitrile-butadiene-styrene copolymers (ABS resins), polyvinyl chloride base resins, fluorocarbon base resins, poly(meth)acryl base resins, polycarbonate base resins, polyester base resins, polyamide base resins, polyimide base resins, polyamideimide base resins, polyaryl phthalate base resins, silicone base resins, polysulfone base resins, polyphenylene sulfide base resins, polyethersulfone base resins, polyurethane base resins, acetal base resins, cellulose base resins and the like.

Among the resins described above, preferred are the polyester base resins and the fluorocarbon base resins each having a high heat resistance, a strength, a weatherability, a durability and a gas barriering property against moisture and the like. In particular, a film comprising the polyester base resin is readily deposited with silver and liable to be provided with a function for enhancing a reflectance, and it can suitably be used as the base material for the light shielding colored layer. The polyester base resin includes, for example, polyethylene terephthalate, polyethylene naphthalate and the like. Among the above polyester base resins, polyethylene terephthalate which is well balanced in terms of various functions such as a heat resistance, a weatherability and the like and a cost is particularly preferably used. The film subjected to surface treatment in order to prevent polyester from being yellowed is preferably used as well.

The fluorocarbon base resin described above includes, for example, polytetrafluoroethylene (PTFE), perfluoroalkoxy resins (PFA) comprising copolymers of tetrafluoroethylene and perfluoroalkyl vinyl ether, copolymers (FEP) of tetrafluoroethylene and hexafluoropropylene, copolymers (EPE) of tetrafluoroethylene, perfluoroalkyl vinyl ether and hexafluoropropylene, copolymers (ETFE) of tetrafluoroethylene and ethylene or propylene, polychlorotrifluoroethylene resins (PCTFE), copolymers (ECTFE) of ethylene and chlorotrifluoroethylene, vinylidene fluoride base resins (PVDF), vinyl fluoride base resins (PVF) and the like. Among the above fluorocarbon base resins, preferred are the polyvinyl fluoride base resins (PVF) and the copolymers (ETFE) of tetrafluoroethylene and ethylene or propylene which are excellent in a strength, a heat resistance, a weatherability and the like.

### Coloring of light shielding colored layer:

The light shielding colored layer is used as a constitutional material at a side brought into contact with a filler at a rear face side of the back sheet for a solar battery for the purpose of reflecting a sunlight transmitted through the solar battery cell to enhance a power generation efficiency and the purpose of reflecting or absorbing a UV ray to thereby prevent a material constituting the above back sheet for a solar battery from being deteriorated by a UV ray and improve various characteristics of the back sheet, such as a weatherability, a durability, a heat resistance, a thermal dimensional stability, a strength and the like. In particular, whitening is effective in terms of reflecting a sunlight to improve the power generation efficiency.
Further, a design property and a decorative property of the solar battery module can be improved by various colorings including blackening.
In the present invention, "light reflection" in "the light shielding colored layer" includes light scattering as well as light reflection.

A method in which a pigment as a colorant is added and dispersed and/or a method in which a non-compatible polymer or fine particles are added to the base material to form voids or air bubbles at a blend interface in stretching the film can be used as a method for coloring the light shielding colored layer.
The pigment used for coloring the base material includes preferably white pigments, black pigments and the like. The white pigments shall not specifically be restricted, and capable of being used are, for example, calcium carbonate, anatase type titanium oxide, rutile type titanium oxide, zinc oxide, lead carbonate, barium sulfate, basic lead carbonate, basic lead sulfate, basic lead silicate, zinc oxide, zinc sulfide, lithopone, antimony trioxide and the like. Titanium oxide of a rutile type is preferred since it is less yellowed than titanium oxide of an anatase type after the polyester film is irradiated with a light for a long time and is suited to inhibiting a change in the color difference.
Among the white pigments described above, at least one kind of inorganic fine particles selected from the group consisting of rutile type titanium oxide, barium sulfate, calcium carbonate and silicon dioxide is preferred in terms of a stability and being a non-heavy metal compound, and barium sulfate and rutile type titanium oxide are more preferred. Barium sulfate is further preferred.

Barium sulfate is a good white material which is physically and chemically stable and which shows a reflectance of 99 % or more over an almost whole area of a visible light, and it is a substance used as a standard of a white color. Further, it is a material which has a high coloring property and a high masking property to carry out efficiently whitening, and it provides a back sheet for a solar battery with a high light reflecting effect.

Capable of being used as a material thereof are barium sulfate (barite powder) produced by crushing barite which is a raw material of barium sulfate and precipitated barium sulfate produced by adding a sodium sulfate solution to a solution of barium sulfide obtained by reducing and roasting barite and precipitating barium sulfate.
Precipitated barium sulfate is preferred because of the reasons that a particle diameter thereof can be controlled by controlling reaction conditions in a producing step thereof and that a fine particle diameter can be achieved.
When barite powder is used, fine barite powder obtained by subjecting barite having a high purity of barium sulfate to mineral processing, crushing and classifying at a high accuracy and controlling a particle diameter thereof to remove coarse particles can be used.
The high purity product in which impurities such as iron, manganese, strontium, calcium and the like are not contained as much as possible is preferably used as barium sulfate.

The black pigment used as the colorant includes, for example, carbon black, black iron oxide and the like, and the coloring agent includes, for example, organic dyes and pigments such as an azo base, an anthraquinone base, a phthalocyanine base, a thioindigo base, a quinacridone base, a dioxazine base and the like, inorganic pigments such as ultramarine, Prussian blue, chrome vermilion, red iron oxide, cadmium red, molybdenum orange and the like, metal powder pigments for metallic gloss. Carbon black and the inorganic pigments are preferred in terms of a long term color stability.
The colorants used in the present invention may be used alone or in combination of two or more kinds thereof.

An average particle diameter of the pigments which are the colorants described above is preferably 5 nm or more and 30 µm or less, more preferably 10 nm or more and 3 µm or less and further preferably 50 nm or more and 1 µm or less. If an average particle diameter of the pigments falls in the ranges described above, a dispersibility thereof into the film resin is prevented from being deteriorated by aggregation, and coarse projections are prevented from being produced on the film. Further, a coloring degree of the film is readily controlled.
An addition amount of the colorant in the light shielding colored layer shall not specifically be restricted as long as it falls in a range in which the above light shielding colored layer can be provided with a desired light shielding property or light scattering property, and usually it falls in a range of preferably 1 to 40 mass %, more preferably 5 to 30 mass % and further preferably 10 to 20 mass % in the light shielding colored layer. If the above addition amount falls in the ranges described above, the film is excellent in a durability, a heat resistance and a strength, and a dispersibility of the pigment in the resin layer is good.

Various methods can be used as a method for adding the pigment to the light shielding colored layer, and it includes, to be specific, (a) a method in which the pigment is added in synthesizing the resin, (b) a method in which the pigment is added to the resin and in which the mixture is molten and kneaded, (c) a method in which the pigment is added in a large amount in the method (a) or the method (b) to prepare a master pellet and in which the master pellet is kneaded with the resin containing no additives to control a concentration thereof to a desired level, (d) a method in which the master pellet prepared in the method (c) described above is used as it is and the like. Among them, the master batch method of (c) is preferred in terms of a concentration controlling property.

In coloring of the base material, particularly whitening thereof, when a polyester base resin is used for the base material in a method for adding a polymer which is non-compatible with the base material or fine particles to form voids or air bubbles at a blend interface in stretching the film, the specific examples of the polymer which is non-compatible with the above resin include polyethylene, polypropylene, polybutene, polymethylpentene and the like. The above polymer may be a homopolymer or a copolymer. Among them, polyolefins having a small critical surface tension are preferred, and polypropylene, polymethylpentene and the like are more preferred in terms of a reduction in a density, a heat resistance and a reduction in a dielectric constant.

A compatibility providing agent may be added to the light shielding colored layer in order to control a particle diameter of the non-compatible polymer in the base material. For example, polyalkylene glycols or copolymer thereof can be used as the above compatibility providing agent, and to be specific, polyethylene glycol, polypropylene glycol and the like are preferably used. Further, a surfactant and the like can be added to the above non-compatible polymer to turn it into fine particles, and they can be added as long as they do not exert influences on the electric characteristics, the heat resistance, the hydrolytic resistance and the like.
Also, the specific examples of the fine particles added to the base material include organic particles and inorganic particles, and the examples of the organic particles include silicone particles, polyimide particles, cross-linked styrenedivinylbenzene copolymer particles, cross-linked polyester particles, fluorine base particles and the like. Further, the inorganic particles include, calcium carbonate, silicon dioxide, barium sulfate and the like.

A method for adding the non-compatible polymer and the fine particles shall not specifically be restricted, and in the case of the non-compatible polymer, a method in which it is supplied to an extruding equipment and dispersed by making use of a shearing force of the above extruding equipment is advantageous in terms of the cost. Also, in the case of the fine particles, a method in which they are added in a polymerization stage is preferred. To be specific, a method in which they are added to ethylene glycol is preferred. Also, when calcium carbonate particles are used, a phosphorus compound is preferably added in adding them to prevent yellowing and foaming.
A method for coloring the light shielding colored layer is preferably coloring by adding a pigment in terms of preventing UV ray deterioration of a gas barriering film positioned at a lower side of the colored film observing from a sunlight receiving side and a weather resistant film since a UV ray can be inhibited from being transmitted.

### Formation and properties of the light shielding colored layer:

The light shielding colored layer can be blended with various additives and the like for the purpose of improving and modifying a processability, a heat resistance, a weatherability, mechanical properties, a dimensional stability and the like. The above additives include, for example, lubricants, cross-linking agents, antioxidants, UV ray absorbers, light stabilizers, fillers, reinforced fibers, reinforcing materials, antistatic agents, fire retardants, flame retardants, foaming agents, fungicides, pigments and the like.
In the present invention, the light shielding colored layer constitutes preferably the back sheet in the form of the light shielding colored film. The light shielding colored film may be any of non-stretched, monoaxially stretched and biaxially stretched films. The molding method shall not specifically be restricted, and the film is produced by a publicly known method such as, for example, an extrusion method, a cast molding method, a T die method, a cutting method, an inflation method and the like. Then, the film may be subjected, if necessary, to monoaxial stretching, simultaneous stretching or sequential biaxial stretching by a tenter method, a tubular method and the like.
Further, the light shielding colored film can be formed by either a single layer extrusion molding method or a multilayer coextrusion molding method. In the case of the coextrusion multilayer film, the respective layers may be colored each, or the middle layer may be colored, and the outer layer may be transparent. When the outer layer is transparent, a use amount of the colorant can be reduced by concentrating the colored layers into the middle layer as compared on a condition on which the same light reflectance as a case of coloring the single layer and the outer layer is provided.

Also, when the outer layer is transparent, the colorant and the void part are not contained, whereby a bonding force between the resins in the outer layer is not weakened. Accordingly, an adhesive property between the outer layer and the filler or an adhesive property between the outer layer and the readily-adhesive layer is improved in the outer layer at a side brought into contact with the filler, and the adhesive property is maintained even under high temperature and high humidity. For example, when the light shielding colored layer comprises a biaxially stretched polyester film containing a white pigment, the polyester resin of the colored layer is advanced in hydrolysis in a case where a weather resistant performance of the weather resistant layer and a gas barriering performance of the gas barriering layer in the back sheet are reduced, and aggregation peeling on a surface layer at a filler side of the colored polyester film is liable to be brought about in a test of peeling from the filler, but in a case where the pigment is added to the middle layer in the coextrusion molding method and where the pigment is not added to the outer layer, the advantage that the aggregation peeling described above is less liable to be brought about is involved therein.

A thickness of the light shielding colored layer can suitably be selected according to uses of the back sheet for a solar battery and the specifications of the solar battery cell and the module, and when the above light shielding colored layer is provided with a sunlight reflection performance, the thickness is preferably 20 to 250 µm, more preferably 50 to 150 µm in terms of obtaining the satisfactory chromaticity and the satisfactory reflection intensity and maintaining the fundamental film strength.
In the present invention, "reflectiveness" in a case where the light shielding colored layer has a reflectiveness means that a transmission factor of light having a wavelength of 350 nm is 1.0 % or less, and it is preferably 0.8 % or less, more preferably 0.5 % or less in terms of the weatherability.
In the present invention, when the light shielding colored layer is a white film, a whiteness degree thereof is measured by a Hunter method, JIS L1015, and a value thereof is preferably 75 % or more, more preferably 80 % or more in terms of enhancing a power generation efficiency of the solar battery.
A thermal shrinkage rate of the colored film is preferably 2 % or less, more preferably 1 % or less, 0.2 to 0.5 %, 0.005 to 0.5 % in heating at 150°C for 30 minutes (JIS C2151) in terms of preventing the productivity from being reduced by shrinkage of the film in heating pressing step in producing the solar battery module.

### Readily-adhesive layer:

The light shielding colored layer is further provided preferably with a readily-adhesive layer at an outside face of the light shielding colored layer constituting the back sheet, that is, a side brought into contact with the filler at a rear face side of the light shielding colored layer in order to improve an adhesive property thereof with an ethylene-vinyl acetate copolymer (EVA), a polyvinyl butyral resin, a modified polyolefin resin and the like which are used as a filler constituting the solar battery module in many case.
The readily-adhesive layer can be provided by various methods, and they include usually a so-called dry laminate method in which a molded readily-adhesive film is adhered on the colored layer by an adhesive and the like, a so-called extrusion laminate method in which a readily-adhesive film is extruded and molded by means of an extruding equipment and adhered soon on the colored layer and a coating method in which the components are dissolved in a solvent, water or the like and in which the solution is coated on a surface of the colored layer.
In this regard, a resin used in the dry laminate method and the extrusion laminate method is suitably a polyolefin base resin. The polyolefin base resin has a high thermal fusion property due to resin characteristics thereof and can maintain firm adhesion with the filler in a high temperature and high humidity test. In a case of the dry laminate method, the adhesive used in the respective layers of the back sheet can be applied as well.
The polyolefin base resin includes polyethylene base resins, polypropylene base resins, mixtures thereof and the like and can suitably be selected according to the heating pressing conditions with the filler and the laminate processing conditions of the back sheet. The examples of the polyethylene base resin include homopolymers of ethylene, low density polyethylene, linear low density polyethylene, high density polyethylene, metallocene base polyethylene and mixtures thereof. The polypropylene base resin include homopolymers of propylene, copolymers of propylene and mixtures thereof. Further, a light stabilizer, a UV absorber, a lubricant, a blocking resistant agent and the like may be added, if necessary, in a range in which the adhesive property with the filler is maintained under high temperature and high humidity.

A thickness of the readily-adhesive layer is 10 to 200 µm, preferably 30 to 150 µm and more preferably 50 to 120 µm, and when it is small, stress relaxation of the filler and the back sheet becomes unsatisfactory in a peeling test, so that they tend to be liable to be peeled. When the thickness is large, a rigidity of the back sheet tends to be unsatisfactory, and curling tends to grow large. In terms of the above matters, a ratio of a thickness of the readily-adhesive layer to a thickness extending from the light shielding colored layer of the back sheet up to the weather resistant polyester base resin layer is 10 to 100 %, preferably 15 to 75 % and more preferably 20 to 50 %. Or, a tensile modulus ratio of a layer summing from the light shielding colored layer up to the weather resistant polyester base resin layer in the back sheet to the readily-adhesive layer resides in a relation of preferably 0.5 to 10 times, more preferably 1 to 8 times and further preferably 2 to 5 times. Also, a thickness unevenness is within ± 10 % in terms of a moldability in vacuum lamination in which the solar battery module is prepared. Further, it is desirable in terms of enhancing the adhesive property to subject a surface of the polyolefin resin layer to surface modifying treatment such as corona discharge treatment, ozone treatment, plasma treatment and the like.

In a case of the coating method described above, the resin used shall not specifically be restricted and includes the respective resins of an acryl base, an epoxy base, a phenol base, a polyester base, a urethane base and a styrene base and modified products thereof. Further, they may be used in a mixture of two or more kinds thereof. Also, either of the oil-based resins and the aqueous resins can be used.
For example, polymers comprising alkyl (meth)acrylate base monomers as principal components are used as the acryl base resin, and polymers obtained by copolymerizing amide group-containing acrylate monomers, hydroxyl group-containing acrylate monomers, glycidyl group-containing acrylate monomers and the like can be used as well. Further, other various polymerizable unsaturated monomers can suitably be copolymerized therewith.
Bisphenol A type epoxy resins, phenol novolac type epoxy resins and the like are representative as the epoxy base resin, and various multifunctional epoxy compounds, for example, glycidyl group-containing acryl base resins and epoxy compounds prepared by reacting glycols, polyhydric alcohols and dicarboxylic acids with epichlorohydrin can be used as well. Compounds having various carboxylic acid groups, an amino group and an oxazoline group can be used as the curing agent.

The polyester base resin includes various resins obtained by using two or more kinds of polybasic acids or ester-forming derivatives thereof and at least one of polyols or ester-forming derivatives thereof.
The urethane base resin includes polyurethanes obtained by reacting polyols of a polyester base, an acryl base and an ether base with diisocyanates and hydrogenated products thereof or polyisocyanates of an adduct body, a buret body and an isocyanurate body as a chain length extension agent. Further, ethyleneimine and derivatives thereof or a carboxylic acid group, a sulfonic acid group and an amino group thereof or salts thereof can be used as well in combination as a functional group reacted with the polyisocyanates described above.
The styrene base resin includes, to be largely classified, styrene-maleic acid copolymers, styrene-vinyl acetate copolymers and styrene-(meth)acryl base copolymers, and the (meth)acryl base monomers described above can be used for the acryl base copolymers.

### <Weather resistant polyester base resin layer>

### Polyester base resin:

A polyester base resin which is excellent in a hydrolytic resistance and a heat resistance is used for the weather resistant polyester base resin layer.
Polyethylene terephthalate, polyethylene naphthalate and polyethylene 2,6-phthalenedicarboxylate are preferably used as the polyester resin in terms of the industrial productivity, and polyethylene terephthalate and polyethylene naphthalate are more preferably used.
A film comprising polyethylene terephthalate is excellent in terms of a transparency, a productivity and a versatility, and a film comprising polyethylene naphthalate is excellent in terms of a high hydrolytic resistance, a heat resistance, a toughness, a low oligomer property and a low vapor permeability.
Polyethylene naphthalate is a polyester resin comprising ethylene naphthalate as a principal repetitive unit, and it is synthesized by using naphthalenedicarboxylic acid as principal dicarboxylic acid and ethylene glycol as a principal glycol component.
From the viewpoint that polyethylene naphthalate used for the above weather resistant polyester base resin layer is excellent in a hydrolytic resistance, a strength and a barriering property, the ethylene naphthalate unit accounts preferably for 80 mole % or more of a whole repetitive unit of the polyester.
The naphthalenedicarboxylic acid described above includes 2,6-naphthalenedicarboxylic acid, 1,4-naphthalenedicarboxylic acid, 1,5-naphthalenedicarboxylic acid, 1,3-naphthalenedicarboxylic acid and the like, and among them, 2,6-naphthalenedicarboxylic acid is preferred in terms of the hydrolytic resistance and the like.

The above polyethylene naphthalate resin contains preferably aromatic polyester. Containing aromatic polyester in polyethylene terephthalate makes it possible to enhance a nodal strength, a peeling resistance, a mechanical strength and the like of the above polyethylene naphthalate film while maintaining a hydrolytic resistance thereof. A content of the above aromatic polyester is preferably 1 to 10 % by mass in the polyethylene naphthalate film. The nodal strength, the peeling resistance, the mechanical strength and the like can effectively be enhanced by controlling a content of the aromatic polyester to the range described above. The above aromatic polyester is, to be specific, preferably polyester obtained by copolymerizing a terephthalic acid component and 4,4'-diphenyldicarboxylic acid as principal dicarboxylic acid components with ethylene glycol as a principal glycol component.

A production process for the above polyester base resin includes, for example, a process in which it is produced by carrying out a first stage reaction of esterifying directly an acid component and a diol component or subjecting dialkyl ester used as the acid component to transesterification reaction with the diol component and then a second stage reaction of melting and polymerizing a product of the above reaction while heating it under reduced pressure to remove the surplus diol component and a process in which it is produced by carrying out a third stage reaction of further subjecting the product of the second stage reaction to solid phase polymerization. The solid phase polymerization is preferably used for obtaining the polyester base resin having a small amount of a carboxy end group.
Also, the above polyester base resin may contain a polyether compound in order to adjust a viscosity of the polyester base resin. The above polyether compound shall not specifically be restricted, and for example, polyether compounds comprising polyethylene oxide or diol as a principal constitutional component can be used as the above polyether compound.

The polyether compound preferably used in the present embodiment includes, for example, polyether compounds comprising at least one of polyethylene oxide, polyethylene glycol, polypropylene glycol, polytetramethylene glycol and copolymers of the above polyether compounds.
Polyether compounds in which ends are blocked may be used as the polyether compound described above. The above polyether compounds in which ends are blocked have the advantage that they can inhibit the polyester base resin from being hydrolyzed. The polyether compounds in which ends are blocked include, for example, polyether compounds in which a hydroxyl group at an end of polyether is subjected to alkyl etherification, that is, ends are blocked by a methoxy group, an ethoxy group and the like.

An average molecular weight of the polyether compound described above shall not specifically be restricted, and it is preferably 500 to 10,000, more preferably 700 to 5,000 in terms of a number average molecular weight from the viewpoint of a compatibility with the polyester base resin.
A content of the polyether compound used in the present embodiment shall not specifically be restricted, and usually it falls in a range of preferably 0.1 to 10 % by mass, more preferably 0.2 to 7 % by mass and particularly preferably 0.2 to 5 % by mass in the polyester base resin.

### Weather resistant polyester base resin layer:

A guarantee period of a solar battery module is prolonged from 10 years to 20 years, 30 years, and a weatherability and a durability of a back sheet for a solar battery have to be improved in order to satisfy the above situation. In this regard, a strength holding rate of the weather resistant polyester base resin layer in the above back sheet for a solar battery after 3000 hours at a temperature of 85°C and a relative humidity of 85 % is preferably 50 % or more, more preferably 60 % or more.
The strength holding rate is shown by a ratio (%) of a rapture strength of the sample after an environmental test at a temperature of 85°C and a relative humidity of 85 % for 3000 hours to that of the sample before the environmental test, wherein the sample is cut from the weather resistant polyester base resin layer in a width of 15 mm, and the tensile rapture strengths thereof before and after the environmental test are measured respectively by means of a tensile test equipment.

A molecular weight, an amount of end carboxyl group, an amount of oligomer and the like of the principal raw material participate in a durability of the above weather resistant polyester base resin layer to a large extent, and an effect of adding a hydrolysis resistant agent, an antioxidant and the like exerts strong influences thereon.
A molecular weight of the polyester base resin falls in a range of preferably 18,000 to 42,000, more preferably 19,000 to 40,000 in terms of a number average molecular weight from the viewpoint of a weatherability, particularly a hydrolytic resistance.

The number average molecular weight can be measured on the following conditions by GPC (gel permeation chromatography) method.
(a) Apparatus: gel permeation chromatograph GCP-244 (manufactured by Waters Corporation)
(b) Column: Shodex HFIP 80M two columns (manufactured by Showa Denko K.K.)
(c) Solvent: hexafluoropropanol (0.005N sodium trifluoroacetate)
(d) Flow rate: 0.5 ml/minute
(e) Temperature: 23°C
(f) Sample concentration: 0.06 % (completely dissolved, filtrated: MyShoriDisk W-13-5)
(g) Injection amount: 0.300 ml
(h) Detector: R-401 differential refractometer (manufactured by Waters Corporation)
(i) Molecular weight calibration: PET-DMT (standard product)

An amount of end carboxyl group of the polyester base resin is preferably 5 to 40 eq/ton, more preferably 5 to 15 eq/ton in terms of a hydrolytic property of the polyester base resin under high temperature and high humidity environment and a durability, a productivity and the like of the back sheet for a solar battery.
An amount of the oligomer which is a low polymer having a repetitive number (polymerization degree) of about 2 to 20 in the polyester base resin is preferably 0.1 to 0.8 % by mass, more preferably 0.5 % by mass or less and further preferably 0.3 % by mass or less in terms of a hydrolytic property thereof. In general, the polyethylene naphthalate resin has preferably the characteristic that an oligomer amount is small.
A content of the oligomer can be analyzed by mass % of the oligomer based on the polyester base resin, wherein 100 mg of the polyester base resin is dissolved in, for example, 2 mL of any solvent of phenol/1,2-dichlorobenzene (mass ratio: 50/50), phenol/1,1,2,2-tetrachloroethane (mass ratio: 50/50), o-chlorophenol and dichloroacetic acid, and the solution is measured by means of a liquid chromatography.

The weather resistant polyester base resin layer contains preferably a carbodiimide compound. End carboxyl groups in the polyester base resin and carboxyl groups produced by hydrolysis are reacted with the carbodiimide compound by adding the carbodiimide compound, and the hydrolytic resistance is enhanced. A content of the above carbodiimide compound is preferably 0.1 to 10 % by mass, more preferably 0.5 to 3 % by mass.

The carbodiimide compound described above includes, for example, monocarbodiimides such as N,N'-diphenylcarbodiimide, N,N'-diisopropylphenylcarbodiimide, N,N'-dicyclohexylcarbodiimide, 1,3-diisopropylcarbodiimide, 1-(3-dimethylaminopropyl)-3-ethylcarbodiimide and the like and polycarbodiimides such as poly(1,3,5-triisopropylphenylene-2,4-carbodiimide) and the like. Among them, N,N'-diphenylcarbodiimide and N,N'-diisopropylphenylcarbodiimide can preferably be used in terms of a versatility. A molecular weight of the carbodiimide compound falls in a range of generally 200 to 1000, particularly preferably 200 to 600 in terms of a dispersibility and a scattering property of the compound.

Further, an antioxidant in addition to the carbodiimide compound described above is preferably added to the polyester base resin. Adding both of the carbodiimide compound and the antioxidant makes it possible to enhance further the hydrolytic resistance described above and inhibit the carbodiimide compound from being decomposed. The antioxidant described above includes, to be specific, hindered phenol base compounds and thioether base compounds, and the hindered phenol base compounds are preferred in terms of an oxidation inhibitory property.
A content of the above antioxidant is preferably 0.05 to 1 % by mass, more preferably 0.1 to 0.5 % by mass in terms of an enhancing effect of a decomposition inhibitory performance and a hydrolytic resistance of the carbodiimide compound and maintaining a color tone of the resin layer. A mass ratio of a content of the antioxidant, to a content of the carbodiimide compound is preferably 0.1 to 1.0, more preferably 0.15 to 0.8 in terms of a sufficiently high effect of inhibiting the hydrolysis. A method for adding the carbodiimide compound and the antioxidant may be either a method in which they are kneaded with the polyester base resin or a method in which they are added at a time of a polycondensation reaction of the resin.

A thickness of the weather resistant polyester base resin layer is preferably 10 to 500 µm, more preferably 25 to 200 µm in terms of a weatherability and a durability. If the thickness is too small, the strength after the test at a temperature of 85°C and a relative humidity of 85 % is reduced to a large extent, and if it is too large, the cost grows higher.

### Formation of the weather resistant polyester base resin layer:

The above weather resistant polyester base resin layer can be produced by a publicly known method. In a case of, for example, producing it in a form of a polyester base resin film, the raw material resin is molten by an extruding equipment and extruded from a circular die or a T die, and the film is rapidly cooled, whereby the non-stretched film which is substantially amorphous and is not oriented can be produced. Further, a single layer film comprising one kind of a resin, a multilayer film comprising one kind of a resin and a multilayer film comprising various kinds of resins can be produced by using a multilayer die.

A film which is stretched at least in a monoaxial direction can be produced by stretching the above non-stretched film in a flowing (vertical axis) direction of the film or in a flowing direction of the film and a direction perpendicular (lateral axis) thereto by a publicly known method such as monoaxial stretching, tenter type sequential biaxial stretching, tenter type simultaneous biaxial stretching, tubular type simultaneous biaxial stretching and the like and thermally fixing it. The stretching magnification and the thermally fixing temperature can optionally be set, and the thermal shrinkage rate at 150°C for 30 minutes resides in a condition of satisfying preferably 1.0 % or less, more preferably 0.1 to 0.5 % and further preferably 0.005 to 0.5 %.
The polyester base resin film is preferably a biaxially stretched polyethylene terephthalate film, a biaxially stretched polyethylene naphthalate film and a coextruded biaxially stretched film of polyethylene terephthalate and/or polyethylene naphthalate with other plastics in terms of the physical properties of the film.

### <Gas barriering layer>

### Base material of gas barriering layer:

Abase material for the gas barriering layer is preferably a thermoplastic high polymer, and it can be used without any specific restrictions as long as it is a resin which can be used for usual packaging materials. To be specific, it includes polyolefins such as homopolymers or copolymers of ethylene, propylene, butene and the like, amorphous polyolefins such as cyclic polyolefins and the like, polyesters such as polyethylene terephthalate, polyethylene 2,6-naphthalate and the like, polyamides such as nylon 6, nylon66, nylon 12, copolymer nylon and the like, ethylene-vinyl acetate copolymer-partially hydrolyzed products (EVOH), polyimides, polyetherimides, polysulfones, polyethersulfones, polyetheretherketones, polycarbonates, polyvinylbutyrals, polyallylates, fluorocarbon resins, acrylate resins and the like. Among them, polyesters, polyamides and polyolefins are preferred in terms of the physical properties of the film. Above all, polyethylene terephthalate and polyethylene naphthalate are more preferred in terms of a strength of the film. Further, polyethylene naphthalate is preferred in terms of a weatherability and a hydrolytic resistance of the film.

The base material for the light shielding colored layer or the base material for the weather resistant polyester base resin layer each described above can be used as the base material for the gas barriering layer, and this makes it possible to provide the gas barriering layer with a light shielding coloring function and a gas barriering function or a gas barriering function and a weather resistant function in combination.
Further, capable of being added to the base material described above are, for example, publicly known additives such as antioxidants, light shielding agents, UV absorbers, hydrolytic resistance-improving agents, plasticizers, sliding agents, fillers, colorants, stabilizing agents, lubricants, cross-linking agents, blocking inhibiters, antioxidants and the like. In particular, 0.1 to 10 % by mass of carbodiimide is preferably added as the hydrolytic resistance-improving agent in terms of enhancing a weatherability of the film.

The base material described above is preferably used in a form of a base material film. The thermoplastic high polymer film as the base material film is molded by using the raw materials described above, and when it is used as the base material film, it may be non-stretched or stretched. Further, it may be laminated with other plastic base materials.
The above base material film can be produced by a publicly known method. For example, the raw material resin is molten by an extruding equipment and extruded from a circular die or a T die, and the film is rapidly cooled, whereby the non-stretched film which is substantially amorphous and is not oriented can be produced. Further, a single layer film comprising one kind of a resin, a multilayer film comprising one kind of a resin and a multilayer film comprising various kinds of resins can be produced by using a multilayer die.

A film which is stretched at least in a monoaxial direction can be produced by stretching the above non-stretched film in a flowing (vertical axis) direction of the film or in a flowing direction of the film and a direction perpendicular (lateral axis) thereto by a publicly known method such as monoaxial stretching, tenter type sequential biaxial stretching, tenter type simultaneous biaxial stretching, tubular type simultaneous biaxial stretching and the like. The stretching magnification can optionally be set, and a thermal shrinkage rate of the film at 150°C for 30 minutes is preferably 0.01 to 3 %, more preferably 0.01 to 1 % and further preferably 0.005 to 0.5 %.
Among them, a biaxially stretched polyethylene terephthalate film, a biaxially stretched polyethylene naphthalate film and a coextruded biaxially stretched film of polyethylene terephthalate and/or polyethylene naphthalate with other plastics are preferred in terms of the physical properties of the film. Further, a biaxially stretched film containing polyethylene naphthalate such as a biaxially stretched polyethylene naphthalate film and a coextruded biaxially stretched film of plastics such as polyethylene terephthalate, polyethylene naphthalate and the like is preferred in terms of a weatherability and a hydrolytic resistance.

A thickness of the base material film is selected in a range of usually 5 to 500 µm, preferably 10 to 200 µm according to the uses thereof in terms of a mechanical strength, a flexibility and the like of the back sheet for a solar battery according to the present invention, and a sheet-like base material having a large thickness is included therein.
Further, in order to improve a coating property and an adhesive property of a weather resistant coating agent for forming the weather resistant coating layer onto the base material film, the film may be subjected to conventional surface treatment such as chemical treatment, discharge treatment and the like before coating the weather resistant coating agent.

### Weather resistant coating layer:

The gas barriering layer has to have a long term weatherability and maintain a gas barriering property in terms of using it in the back sheet for a solar battery. Accordingly, in the present invention, the weather resistant coating layer is formed in order to provide the base material film with a bleed-out inhibitory property and an adhesive property with an inorganic thin film from the viewpoint of a long term weatherability of the gas barriering layer.
In the present invention, the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

### (a) Cross-linked product of polycaprolactonepolyol and/or polycarbonatepolyol:

Polyesterpolyol and polyetherpolyol have so far been used as an anchor coating agent in many cases, and polyesterpolyol is liable to be hydrolyzed. Polycaprolactonepolyol is excellent in a moisture resistance as compared with adipate polyesterpolyol, and it is excellent in a weatherability and a heat resistance as compared with polyetherpolyol. Further, polycarbonatepolyol is excellent in a heat resistance, a moisture resistance and a weatherability as compared with polyesterpolyol and polyetherpolyol. From the viewpoints described above, the cross-linked product of polycaprolactonepolyol and/or polycarbonatepolyol is used as the weather resistant coating agent in the present invention.
Polycaprolactonepolyol and polycarbonatepolyol can improve the interlayer adhesive property as compared with polyesterpolyol by means such as controlling a degree of surface treatment including corona treatment and the like in the base material film, coating very thinly in advance only an adhesive component such as a cross-linking agent and the like, a silane coupling agent and a titanium base coupling agent and increasing a blend ratio of a cross-linking compound in a coating material, and this makes it possible to improve more a weatherability of the coated layer.

### Polycaprolactonepolyol:

Polycaprolactonepolyol is produced by subjecting ε-caprolactone to ring-opening polymerization using polyhydric alcohol shown below as an initiator under the presence of a catalyst according to a publicly known method.
Polyhydric alcohol which is an initiator for ε-caprolactone includes ethylene glycol, diethylene glycol, 1,2-propylene glycol, dipropylene glycol, 1,3-butanediol, 1,4-butanediol, 1,6-hexanediol, neopentyl glycol, trimethylolpropane, glycerin, pentaerythritol and polytetramethylene ether glycol. Further, capable of being used as well are aliphatic polyhydric alcohols such as polymerization products or copolymerization products which are obtained by subjecting ethylene oxide, propylene oxide and butylene oxide to ring-opening polymerization using the above polyhydric alcohols as an initiator; polyhydric alcohols containing a cyclohexyl group such as cyclohexanedimethanol, cyclohexanediol, hydrogenated bisphenol A and polymerization products or copolymerization products which are obtained by subjecting ethylene oxide, propylene oxide and butylene oxide to ring-opening polymerization using the above glycols as an initiator; polyhydric alcohols containing an aromatic group such as bisphenol A, hydroquinonebis(2-hydroxyethyl ether), p-xylene glycol, bis(β-hydroxyethyl) terephthalate and polymerization products or copolymerization products which are obtained by adding ethylene oxide, propylene oxide and butylene oxide using the above glycols as an initiator; and polyhydric alcohols containing various functional groups including glycols having carboxyl groups such as dimethylolpropionic acid, diphenolic acid and the like and glycols having tertiary amines such as N-methyldiethanolamine and the like.

### Polycarbonatepolyol:

Polycarbonatepolyol can be prepared by a publicly known method. Preferably used as polycarbonatediol are polycarbonatediols obtained by reacting diphenyl carbonate or phosgene with aliphatic diol having 2 to 12 carbon atoms, such as 1,4-butanediol, 1,5-pentanediol, 1,6-hexanediol, 1,8-octanediol, 1,10-decanediol and the like or mixtures thereof to subject them to polycondensation.

Ether-modified polycarbonatepolyols having a repetitive structural unit of -[(CH₂)₃-OC(O)O]- or -[(CH₂)₂(CCH₃)(CH₂)₂-OC(O)O]-, which are obtained by reacting polyalkylenecarbonatepolyols having a number average molecular weight of 10,000 or less, preferably 500 to 5,000 with polyethylene glycol monoalkyl ethers having a number average molecular weight of 5,000 or less are preferred in terms of a compatibility with an organic solvent and a cross-linking agent. Incidentally, the number average molecular weight is a polystyrene-reduced value obtained by the gel permeation chromatographic analysis described above.
Polycarbonatepolyol has preferably an end hydroxyl group index of 92.5 to 98.5, more preferably 95.0 to 97.5 in terms of carrying out homogeneously cross-linking reaction with a cross-linking agent, that is, preventing a partial increase in a molecular weight and controlling a molecular weight distribution of the product and a hydrolytic resistance thereof after cross-linking. The end hydroxyl group index is shown by a ratio (%) of a peak area of polyol to a total peak area of monoalcohol and polyol which are analyzed by a gas chromatography. The gas chromatography is analyzed by means of a flame ionization detector (FID), wherein the temperature is elevated from 40°C up to 220°C at 10°C/minute and maintained for 15 minutes.

### Cross-linking agent:

A cross-linking agent for obtaining the cross-linked product of polycaprolactonepolyol and/or polycarbonatepolyol shall not specifically be restricted as long as it is a compound or a polymer having two or more functional groups per molecule which are subjected to cross-linking curing reaction with hydroxyl groups present in the polycaprolactonepolyol and/or the polycarbonatepolyol described above, and at least one of them can suitably be selected and used.
For example, compounds or polymers having a phenol group, an epoxy group, a melamine group, an isocyanate group and a dialdehyde group are shown as the examples of the cross-linking agent. Compounds or polymers having an epoxy group, a melamine group and an isocyanate group are preferred in terms of a cross-linking reactivity and a pot life, and isocyanate compounds and/or epoxy compounds are more preferred in terms of controlling a pot life. In particular, isocyanate compounds are desirable in terms of a reactivity of a component in a two-component reactive coating agent, a weatherability originating therein and a hardness and a flexibility of the coated layer.

### (b) Cross-linked product of modified polyvinyl alcohol:

The modified polyvinyl alcohol includes resins obtained by modifying a hydroxyl group of polyvinyl alcohol to a silanol group, a silyl group, an amino group, an ammonium group, an alkyl group, an isocyanate group, an oxazoline group, a methylol group, a nitrile group, an acetoacetyl group, a cation group, a carboxyl group, a carbonyl group, a sulfone group, a phosphoric acid group, an acetal group, a ketal group, a carbonate ester group, a cyanoethyl group and the like. Among them, resins modified to acetacetal and butyral are preferred in terms of a moisture resistance under high temperature and high humidity.
A hydroxyl group remains in the modified polyvinyl alcohol, and therefore cross-linking of the hydroxyl group makes it possible to enhance further the moisture resistance.

### Polyvinyl butyral:

Polyvinyl butyral which is a modified product produced by butyral modification can be prepared by a publicly known method, and polyvinyl butyral having a butyral modification degree of preferably 50 to 80 mol %, more preferably 60 to 75 mol % and an isotactic triad type remaining hydroxyl group amount of preferably 1 mol % or less, more preferably 0.5 mol % or less is preferred in terms of having the good weatherability, enhancing the solvent solubility and obtaining- the uniform coated layer.
A weatherability and a solvent solubility of polyvinyl butyral depends on a butyral modification degree, and polyvinyl butyral preferably has high butyral modification degree. However, polyvinyl alcohol can not be modified to butyral by 100 mol %, and it is not efficient in terms of industrial production to enhance the butyral modification degree to the maximum. Further, the solvent solubility is changed according to the kind of the remaining hydroxyl groups, and if the isotactic triad type hydroxyl group remains more, the Polyvinyl butyral is inferior in a solubility to the organic solvent.

### Polyvinyl acetacetal:

Polyvinyl acetacetal which is a modified product produced by acetacetal modification can be prepared by a publicly known method. The high acetal modification degree is desirable in terms of the heat resistance, and the acetal modification degree is preferably 50 to 80 mol %, more preferably 65 to 80 mol % mol %. A suitable amount of aldehyde having 3 or more carbon atoms is preferably mixed to maintain the mixture at a suited temperature after an acetal product is deposited in terms of obtaining a polyvinyl acetacetal resin having a narrow particle diameter distribution in order to enhance the solvent solubility to form the uniform coated layer.

### Cross-linking agent:

A cross-linking agent for obtaining the cross-linked product of modified polyvinyl alcohol shall not specifically be restricted as long as it is a compound or a polymer having two or more functional groups per molecule which are subjected to cross-linking curing reaction, and at least one of them can suitably be selected and used according to the kind of a functional group present in the modified polyvinyl alcohol described above.
For example, when cross-linking a hydroxyl group of modified polyvinyl alcohol, compounds or polymers having a phenol group, an epoxy group, a melamine group, an isocyanate group and a dialdehyde group are shown as the examples of a cross-linkable compound. Compounds or polymers having an epoxy group, a melamine group and an isocyanate group are preferred in terms of a cross-linking reactivity and a pot life, and compounds or polymers having an isocyanate group are particularly preferred in terms of controlling a pot life.

### (c) Acryl base copolymer having at least one group selected from the group consisting of a UV ray stabilizing group, a UV ray absorbing group and a Cycloalkyl group:

In general, a method for providing a polymer with a weatherability includes a method in which a UV ray stabilizing agent and a UV ray absorbing agent are added. The above agents having a relatively low molecular weight bleed out from a principal material in long term use, and a weatherability thereof is less liable to be maintained. In the above weather resistant coating, they can show a weatherability over a long period of time without bleeding-out by copolymerizing a UV ray stabilizing group and a UV ray absorbing group with a cycloalkyl group having a moisture resistance.

In the present invention, the UV ray stabilizing group has a function of capturing generated radicals to inactivate them and includes preferably, to be specific, a hindered amine group in terms of the matter described above. That is, a stable nitroxy radical generated in a hindered amine group is combined with an active polymer radical, and the radical itself returns to the original stable nitroxy radical. This operation is repeated.
Also, the UV ray absorbing group inhibits generation of radicals by absorbing a UV ray radiated and includes preferably, to be specific, a benzotriazole group and/or a benzophenone group in terms of the above matter.
The cycloalkyl group has a function of providing the resin such as the acryl base copolymer and the like constituting the weather resistant coating layer with a moisture resistance and a vapor permeating resistance.

Accordingly, deterioration of a gas barrier in the gas barriering film can be prevented by using the resin such as the acryl base copolymer having at least one group selected from the group consisting of a UV ray stabilizing group, a UV ray absorbing group and a cycloalkyl group for the coating layer. In the present invention, a synergistic effect can be obtained in terms of the weatherability by having a UV ray stabilizing group, a UV ray absorbing group and a cycloalkyl group in combination.
The acryl base copolymer described above can be obtained by copolymerizing at least one selected from the group consisting of a polymerizable UV ray stabilizing monomer, a polymerizable UV ray absorbing monomer and cycloalkyl (meth)acrylate.

### Polymerizable UV ray stabilizing monomer:

The polymerizable UV ray stabilizing monomer has preferably a hindered amine group, more preferably each at least one hindered amine group and polymerizable unsaturated group in a molecule.
The Polymerizable UV ray stabilizing monomer is preferably a compound represented by the following Formula (1) or (2):

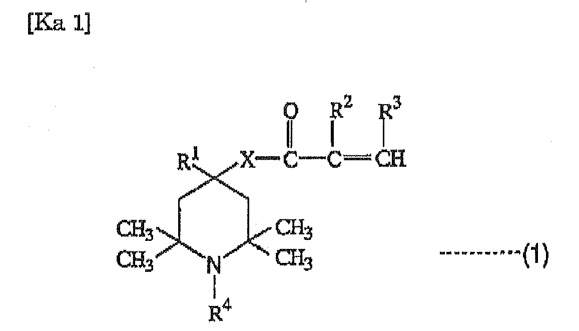

(wherein R¹ represents a hydrogen atom or a cyano group; R² and R³ each represent independently a hydrogen atom or a hydrocarbon group having 1 or 2 carbon atoms; R⁴ represents a hydrogen atom or a hydrocarbon group having 1 to 18 carbon atoms; and X represents an oxygen atom or an imino group);

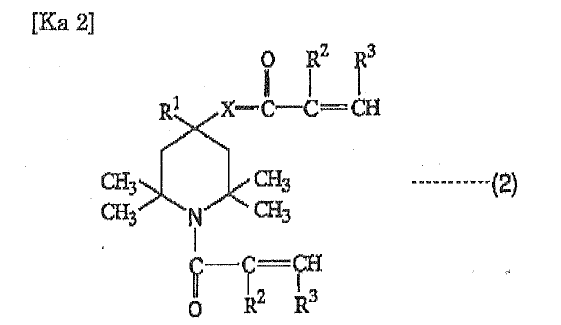

(wherein R¹ represents a hydrogen atom or a cyano group; R² and R³ each represent independently a hydrogen atom or a hydrocarbon group having 1 or 2 carbon atoms; and X represents an oxygen atom or an imino group).

In the polymerizable UV ray stabilizing monomer represented by Formula (1) or (2), the hydrocarbon group having 1 to 18 carbon atoms represented by R⁴ includes, to be specific, chain hydrocarbon groups such as methyl, ethyl, propyl, isopropyl, butyl, isobutyl, t-butyl, pentyl, hexyl, heptyl, octyl, nonyl, decyl, undecyl, dodecyl, tridecyl, tetradecyl, pentadecyl, hexadecyl, heptadecyl, octadecyl and the like; alicyclic hydrocarbon groups such as cyclopropyl, cyclopentyl, cyclohexyl, cycloheptyl, cyclooctyl and the like; and aromatic hydrocarbon groups such as phenyl, tolyl, xylyl, benzyl, phenethyl and the like. Among them, in the present invention, R⁴ is preferably a hydrogen atom and methyl in terms of a light stabilizing reactivity.
The hydrocarbon group having 1 or 2 carbon atoms represented by each of R² and R³ includes, for example, methyl, ethyl and the like, and it is preferably methyl.

The polymerizable UV ray stabilizing monomer represented by Formula (1) includes, to be specific, 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine, 4-(meth)acryloylamino-1,2,2,6,6-pentamethylpiperidine, 4-cyano-4-(meth)acryloylamino-2,2,6,6-tetramethylpiperidine, 4-crotonoyloxy-2,2,6,6-tetramethylpiperidine, 4-crotonoylamino-2,2,6,6-tetramethylpiperidine and the like. Among them, in the present invention, 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine and 4-(meth)acryloylamino-1,2,2,6,6-pentamethylpiperidine are preferred in terms of a light stabilizing reactivity, and 4-methacryloyloxy-2,2,6,6-tetramethylpiperidine and 4-methacryloyloxy-1,2,2,6,6-pentamethylpiperidine are more preferred. They may be used alone or in a suitable mixture of two or more kinds thereof. It is a matter of course that the Polymerizable UV ray stabilizing monomer represented by Formula (2) shall not be restricted to the above compounds.

The polymerizable UV ray stabilizing monomer represented by Formula (2) includes, to be specific, 1-(meth)acryloyl-4-(meth)acryloylamhxo-2,2,6,6-tetramethylpiperidine, 1-(meth)acryloyl-4-cyano-4-(meth)acryloylamino-2,2,6,6-tetramethylpiperidine, 1-crotonoyl-4-crotonoyloxy-2,2,6,6-tetramethylpiperidine and the like. Among them, in the present invention, 1-acryloyl-4-acryloylamino-2,2,6,6-tetramethylpiperidine and 1-methacryloyl-4-methacryloylamino-2,2,6,6-tetramethylpiperidine are preferred in terms of a raw material versatility, and 1-methacryloyl-4-methacryloylamino-2,2,6,6-tetramethylpiperidine is more preferred. They may be used alone or in a suitable mixture of two or more kinds thereof. The polymerizable UV ray stabilizing monomer represented by Formula (2) shall not be restricted to the above compounds.

The polymerizable UV ray stabilizing monomer described above is contained in a range of preferably 0.1 to 50 % by mass, more preferably 0.2 to 10 % by mass and further preferably 0.5 to 5 % by mass based on the whole Polymerizable monomer components in terms of a light stabilizing performance. If the content falls in the ranges described above, the weatherability is sufficiently exerted.

### Polymerizable UV ray absorbing monomer:

The polymerizable UV ray absorbing monomer used in the present invention includes preferably polymerizable benzotriazoles and/or polymerizable benzophenones.

### (a) Polymerizable benzotriazoles:

In the present invention, the polymerizable benzotriazoles are, to be specific, preferably compounds represented by the following Formula (3) and Formula (4):

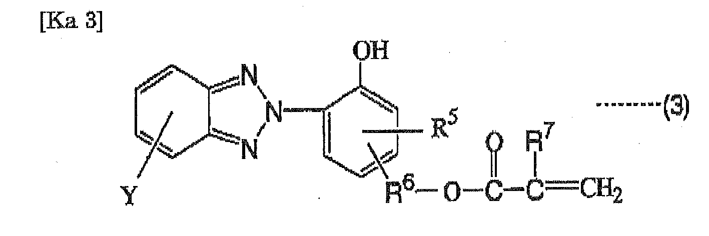

(wherein R⁵ represents a hydrogen atom or a hydrocarbon group having 1 to 8 carbon atoms; R⁶ represents a lower alkylene group; R⁷ represents a hydrogen atom or methyl; and Y represents a hydrogen atom, a halogen atom, a hydrocarbon group having 1 to 8 carbon atoms, a lower alkoxy group, a cyano group or a nitro group);

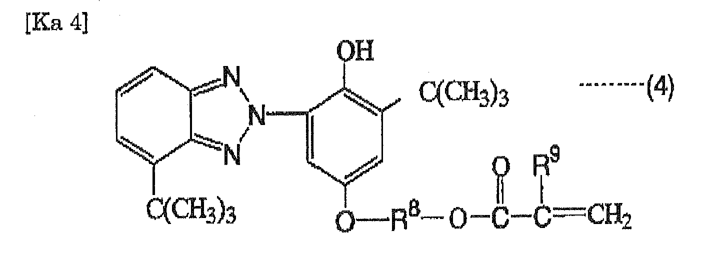

(wherein R⁸ represents an alkylene group having 2 or 3 carbon atoms, and R⁹ represents a hydrogen atom or methyl).

In the formula described above, the hydrocarbon group having 1 to 8 carbon atoms represented by R⁵ includes, to be specific, chain hydrocarbon groups such as methyl, ethyl, propyl, isopropyl, butyl, isobutyl, t-butyl, pentyl, hexyl, heptyl, octyl and the like; alicyclic hydrocarbon groups such as cyclopropyl, cyclopentyl, cyclohexyl, cycloheptyl, cyclooctyl and the like; and aromatic hydrocarbon groups such as phenyl, tolyl, xylyl, benzyl, phenethyl and the like. R⁵ is preferably a hydrogen atom or methyl.

The lower alkylene group represented by R⁶ is preferably an alkylene group having 1 to 6 carbon atoms and includes, to be specific, linear alkylene groups such as methylene, ethylene, propylene, butylene, pentylene, hexylene and the like and branched chain alkylene groups such as isopropylene, isobutylene, s-butylene, t-butylene, isopentylene, neopentylene and the like, and it is preferably methylene, ethylene and propylene.
The substituent represented by Y includes hydrogen; halogens such as fluorine, chlorine, bromine and iodine; the hydrocarbon group having 1 to 8 carbon atoms represented by R⁵; lower alkoxy groups having 1 to 8 carbon atoms such as methoxy, ethoxy, propoxy, butoxy, pentoxy, heptoxy and the like; a cyano group; and a nitro group, and it is preferably a hydrogen atom, a chlorine atom, methoxy, t-butyl, a cyano group and a nitro group in term of reactivity.

The polymerizable UV ray absorbing monomer represented by Formula (3) described above includes, to be specific, 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-3'-t-butyl-5'-(methacryloyloxyethyl)phenyl]-2H-benzotriazole, 2-[2'-hydroxy-5'-t-butyl-3'-(methacryloyloyethyl)phenyl]-2H-benzotriazole, 2-[2-hydroxy-5'-(methacryloyloxyethyl)phenyl]-5-chloro-2H-benzotriazole, 2-[2'-hydroxy-5'-(methacryloyloxyethyl)phenyl]-5-methoxy-2H-benzotriazole, 2-[2'-hydroxy-5'-(methacryloyloxyethyl)phenyl]-5-cyano-2H-benzotriazole, 2-[2'-hydroxy-5'-(methacryloyloxyethyl)phenyl]-1-butyl-2H-benzotriazole, 2-[2'-hydroxy-5'-(methacryloyloxyethyl)phenyl]-5-nitro-2H-benzotriazole and the like. Preferred in terms of a UV ray absorbing property are 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-8'-t-butyl-5'-(methacryloyloxy-ethyl)phenyl]-2H-benzotriazole and 2-[2'-hydroxy-5'-(methacryloyloxyethyl)phenyl]-t-butyl-2H-benzotriazole, and more preferred are 2-[2'-hydroxy-5'-(methacryloyloxymethyl)-phenyl]-2H-benzotriazole and 2-[2'-hydroxy-5'-(methacryloyloxyethyl)phenyl]-2H-benzotriazole. The above polymerizable UV ray absorbing monomers represented by Formula (3) may be used alone or in a suitable mixture of two or more kinds thereof.

In the Polymerizable UV ray absorbing monomer represented by Formula (4) described above, the alkylene group having 2 or 3 carbon atoms represented by R⁸ in the formula is, to be specific, ethylene, trimethylene, propylene and the like.
The polymerizable UV ray absorbing monomer represented by Formula (4) described above includes, for example, 2-[2'-hydroxy-5'-(β-methacryloyloxyethoxy)-3'-t-butylphenyl]-4-t-butyl-2H-benzotriazole, 2-[2'-hydroxy-5'-(β-acryloyloxyethoxy)-3'-t-butylphenyl]-4-t-butyl-2H-benzotriazole, 2-[2'-hydroxy-5'-(β-methacryloyloxy-n-propoxy)-3'-t-butylphenyl]-4-t-butyl-2H-benzotriazole and 2-[2'-hydroxy-5'-(β-methacryloyloxy-i-propoxy)-3'-t-butylphenyl]-4-t-butyl-2H-benzotriazole, and it is preferably 2-[2'-hydroxy-5'-(β-methacryloyloxyethoxy)-3'-t-butylphenyl]-4-t-butyl-2H-benzotriazole in terms of a UV ray absorbing property. The above polymerizable UV ray absorbing monomers represented by Formula (4) may be used alone or in a suitable mixture of two or more kinds thereof.

### (b) Polymerizable benzophenones:

The polymerizable benzophenones used as the polymerizable UV ray absorbing monomer include, for example, monomers such as 2-hydroxy-4-(3-methacryloyloxy-2-hydroxy-propoxy)benzophenone, 2-hydroxy-4-(3-acryloyloxy-2-hydroxy-propoxy)benzophenone, 2,2'-dihydroxy-4-(3-methacryloyloxy-2-hydroxypropoxy)benzophenone, 2,2'-dihydroxy-4-(3-acryloyloxy-2-hydroxypropoxy)benzophenone and the like which are obtained by reacting 2,4-dihydroxybenzophenone or 2,2',4-trihydroxybenzophenone with glycidyl acrylate or glycidyl methacrylate. They are preferably 2-hydroxy-4-(3-methacryloyloxy-2-hydroxypropoxy)benzophenone in terms of a raw material versatility.

The Polymerizable UV ray absorbing monomer is used in order to further enhance a weatherability of the coating layer containing the acryl copolymer obtained, and a content thereof in the whole polymerizable monomer components is described below. In a case of the Polymerizable benzotriazoles, it is preferably 0.1 to 50 % by mass, more preferably 0.5 to 40 % by mass and further preferably 1 to 30 % by mass in terms of the satisfactory UV ray absorbing performance and prevention of coloring caused by irradiation with a UV ray. In a case of the polymerizable benzophenones, a content thereof is preferably 0.1 to 10 % by mass, more preferably 0.2 to 5.0 % by mass in terms of a satisfactory UV ray absorbing performance and a good compatibility.

### Cycloalkyl (meth)acrylate:

Cycloalkyl (meth)acrylate used in the present invention is a component used in order to enhance a hardness, an elasticity, a solvent resistance, a gasoline resistance and a weatherability of the coating film when the acryl copolymer obtained is used particularly for a two-component urethane resin coating material. For example, cyclohexyl (meth)acrylate, methylcyclohexyl (meth)acrylate, t-butylcyclohexyl (meth)acrylate, cyclododecyl (meth)acrylate and the like can preferably be listed as the cycloalkyl (meth)acrylate. They can be used alone or in combination of two or more kinds thereof. The above cycloalkyl (meth)acrylate is used in a range of preferably 5 to 80 % by mass, more preferably 10 to 70 % by mass and further preferably 15 to 50 % by mass based on the polymerizable monomer components, If the use amount falls in the ranges described above, the performances of the coating film, such as a hardness, a weatherability and the like are sufficiently exerted, and the drying property and the leveling property are compatibly obtained.

### Cross-linking functional group:

In the weather resistant coating layer described above, the acryl base copolymer has a cross-linking functional group and is cross-linked with the cross-linking agent, whereby the cross-linked resin is preferably formed. This provides the acryl base copolymer with a cross-linked structure, and therefore a physical property and a weatherability of the coating layer are enhanced. As a result thereof, the excellent weather resistant performance is maintained over a long period of time.
The cross-linking functional group contained in the acryl base copolymer described above includes, for example, a hydroxyl group, an amino group, a carboxyl group or an anhydride thereof, an epoxy group, an amide group and the like. The above cross-linking functional groups may be present alone or in a plurality of two or more kinds thereof in the acryl base copolymer. In the present invention, among the above cross-linking functional groups, the groups having active hydrogen such as a hydroxyl group, an amino group, a carboxyl group and the like are preferred in terms of a stability.

Capable of being listed as the polymerizable unsaturated monomer having a hydroxyl group are, for example, (meth)acryl monomers having a hydroxyl group, such as hydroxyethyl (meth)acrylate, hydroxypropyl (meth)acrylate, caprolactone-modified hydroxy (meth)acrylate and mono(meth)acrylates of polyester diols which are obtained from phthalic acid and propylene glycol, and it is preferably hydroxypropyl acrylate and hydroxyethyl methacrylate. They can be used alone or in combination of two or more kinds thereof.
When the acryl base copolymer obtained is blended with other cross-linking compounds including polyisocyanate to prepare a resin composition for a thermosetting type coating material, the polymerizable monomer containing a cross-linking functional group is a component necessary for reaction with the above cross-linking compounds, and it is used in a range of 2 to 35 % by mass, preferably 3.5 to 23 % by mass based on the whole polymerizable monomer components. If the use amount falls in the ranges described above, an amount of a cross-linking functional group contained in the acryl base copolymer obtained is suitable; a reactivity of the above acryl base copolymer with the cross-linking compound is maintained; the cross-linking density is satisfactory; and the targeted coating film performances are obtained. Further, the storage stability after blended with the cross-linking compound is good.

### Other polymerizable unsaturated monomers:

In the present invention, other Polymerizable unsaturated monomers for forming the acryl base copolymer can be used.
The other polymerizable unsaturated monomers used in the present invention include, for example, (meth)acrylic acid alkyl esters such as methyl (meth)acrylate, ethyl (meth)acrylate, propyl (meth)acrylate, isopropyl (meth)acrylate, butyl (meth)acrylate, isobutyl (meth)acrylate, tertiary butyl (meth)acrylate, 2-ethylhexyl (meth)acrylate, lauryl (meth)acrylate, stearyl (meth)acrylate and the like; epoxy group-containing unsaturated monomers such as glycidyl (meth)acrylate and the like; nitrogen-containing unsaturated monomers such as (meth)acrylamide, N,N'-dimethylaminoethyl (meth)acrylate, vinylpyridine, vinylimidazole and the like; halogen-containing unsaturated monomers such as vinyl chloride, vinylidene chloride and the like; aromatic unsaturated monomers such as styrene, a -methylstyrene, vinyltoluene and the like; vinylesters such as vinylacetate and the like; vinylethers; and unsaturated cyan compounds such as (meth)acrylonitrile and the like. At least one compound selected from the above groups can be used.

Further, a polymerizable unsaturated monomer having an acid functional group can be used as well in terms of an internal catalytic action in cross-linking reaction, and capable of being listed are, for example, carboxyl group-containing unsaturated monomers such as (meth)acrylic acid, crotonic acid, itaconic acid, maleic acid, maleic anhydride and the like; sulfonic acid group-containing unsaturated monomers such as vinylsulfonic acid, styrenesulfonic acid, sulfoethyl (meth)acrylate and the live; and acid phosphoric acid ester base unsaturated monomers such as 2-(meth)acryloyloxyethyl acid phosphate, 2-(meth)acryloyloxypropyl acid phosphate, 2-(meth)acryloyloxy-2-chloropropyl acid phosphate, 2-(meth)acryloyloxyethylphenyl phosphate and the like. At least one compound selected from the above groups can be used.

The other polymerizable unsaturated monomers described above can be used, if necessary, as long as the actions of the acryl base copolymer in the method of the present invention are not damaged, and a use amount thereof can be 0 to 92.9 % by mass based on the polymerizable monomer components. Also, the polymerizable monomers having an acid functional group among the other polymerizable unsaturated monomers function as an internal catalyst used when the acryl base copolymer is subjected to cross-linking reaction with the cross-linking agent, and an amount thereof can be 0 to 5 % by mass, preferably 0.1 to 3 % by mass based on the polymerizable monomer components,

### Polymerization method of the acryl base copolymer:

A method for obtaining the acryl base copolymer using the monomers described above shall not specifically be restricted, and publicly known polymerization methods can be used.
For example, when a solution polymerization method is used, capable of being listed as solvents which can be used are, for example, aromatic solvents having a high boiling point, such as toluene, xylene and the like; ester base solvents such as ethyl acetate, butyl acetate, cellosolve acetate, propylene glycol monomethyl ether acetate and the like; ketone base solvents such as methyl ethyl ketone, methyl isobutyl ketone and the like; aliphatic alcohols such as isopropanol, n-butanol, isobutanol and the like; and alkylene glycol monoalkyl ethers such as propylene glycol monomethyl ether, propylene glycol monoethyl ether, diethylene glycol monoethyl ether and the like, and they can be used alone or in a mixture of two or more kinds thereof.

Also, capable of being listed as the polymerization initiator are usual radical polymerization initiators such as 2,2'-azobis(2-methylbutyronitrile), t-butylperoxy-2-ethyl hexanoate, 2,2'-azobisisobutyronitrile, benzoyl peroxide, di-t-butyl peroxide and the like. They may be used alone or in combination of two or more kinds thereof. A use amount thereof shall not specifically be restricted and can suitably be set according to the characteristics of the desired acryl resin.
The reaction conditions such as the reaction temperature, the reaction time and the like shall not specifically be restricted, and for example, the reaction temperature falls in a range of room temperature to 200°C, preferably 40 to 140°C. The reaction time can suitably be set according to a composition of the monomer components and the kind of the polymerization initiator so that the polymerization reaction is completed.

### Cross-linking agent:

The cross-linking agent shall not specifically be restricted as long as it is a compound or a polymer having two or more functional groups per molecule which are subjected to cross-linking curing reaction with the cross-linking functional groups described above, and at least one of them can suitably be selected and used according to the kind of a functional group contained in the acryl base copolymer described above.
If a cross-linking functional group contained in the acryl base copolymer is, for example, a hydroxyl group, compounds or polymers having a phenol group, an epoxy group, a melamine group, an isocyanate group and a dialdehyde group are shown as the examples of the cross-linking agent. Compounds or polymers having an epoxy group, a melamine group and an isocyanate group are preferred in terms of a cross-linking reactivity and a pot life, and compounds or polymers having an isocyanate group are particularly preferred in terms of controlling a pot life.

When a cross-linking functional group contained in the acryl base copolymer is a carboxyl group or an anhydride thereof, the cross-linking agent includes cross-linking compounds such as polyisocyanate compounds or modified products thereof, aminoplast resins, epoxy resins and the like, and when the cross-linking functional group is an epoxy group, it includes cross-linking agents containing compounds such as amines, carboxylic acids, amides, N-methylolalkyl ethers and the like. When the cross-linking functional group is a hydroxyl group and an amino group, it includes cross-linking agents such as polyisocyanate compounds or modified products thereof, epoxy resins, aminoplast resins and the like. Among them, it is preferably the polyisocyanate compound and/or the epoxy resin in combination with groups having active hydrogen.
In the acryl base copolymer described above, combination in which the cross-linking functional group is a hydroxyl group and in which the cross-linking agent is an isocyanate compound is preferred as a two-component reactive coating agent in terms of a reactivity of the components and a weatherability originating therein and a hardness and a flexibility of the coating layer.

### Cross-linking agent in weather resistant coating layer:

As described above, the isocyanate compound as the cross-linking agent is preferably used for a weather resistant coat of the gas barriering layer, and polyisocyanate is preferably used as the isocyanate compound. The polyisocyanate may be one of diisocyanate, a dimer thereof (uretdione), a trimer thereof (isocyanurate, triol adducts, buret) and the like or a mixture of two or more kinds thereof. The diisocyanate component includes, for example, 2,4-tolylenediisocyanate, 2,6-tolylenediisocyanate, p-phenylenediisocyanate, diphenylmethanediisocyanate, m-phenylenediisocyanate, hexamethylenediisocyanate, tetramethylenediisocyanate, 3,3'-dimethoxy-4,4'-biphenylenediisocyanate, 1,5-naphthalenediisocyanate, 2,6-naphthalenediisocyanate, 4,4'-diisocyanate diphenyl ether, 1,5-xylylenediisocyanate, 1,3-diisocyanatemethylcyclohexane, 1,4-diisocyanatemethylcyclohexane, 4,4-diisocyanatecyclohexane, 4,4'-diisocyanatecyclohexylmethane, isophoronediisocyanate, dimer acid diisocyanate, norbornenediisocyanate and the like. Further, a xylylenediisocyanate (XDI) base, an isophoronediisocyanate (IPDI) base, a hexamethylenediisocyanate (HDI) base and the like are preferred in terms of a no-yellowing property. Also, an isocyanurate body and a buret body of hexamethylenediisocyanate are good in terms of a fastness, a gas barriering property and a weatherability.

The epoxy compound shall not specifically be restricted as long as it is a compound having two or more epoxy groups in a molecule and includes, for example, sorbitol polyglycidyl ether, sorbitan polyglycidyl ether, polyglycerol polyglycidyl ether, pentaerythritol polyglycidyl ether, triglycidyl, tris(2-hydroxyethyl) isocyanurate, neopentyl glycol diglycidyl ether, 1,6-hexanediol diglycidyl ether, ethylene glycol diglycidyl ether, epoxy resins of a bisphenol A type and the like.

A use amount of the cross-linking agent described above shall not specifically be restricted and can suitably be determined according to the kind and the like of the cross-linking agent, and a reactive group ratio of the cross-linking groups (for example, a hydroxyl group) of the polycaprolactonepolyol, the polycarbonatepolyol, the modified polyvinyl alcohol and the acryl base copolymer each described above to the cross-linking groups of the cross-linking compounds is desirably the hydroxyl group: the cross-linking group = 1:1 1 to 1 : 20, preferably 1 : 1 to 1 : 10 in terms of the in-layer coagulation power and the interlayer adhesive property. If the cross-linking group ratio falls in the ranges described above, it is advantageous in terms of the adhesive property, the high temperature & high humidity resistance, the gas barriering property, the blocking resistance and the like.
Further, at least one cross-linking catalyst such as salts, inorganic substances, organic substances, acid substances, alkali substances and the like may be added to the cross-linking agent described above in order to accelerate the cross-linking reaction. For example, when the polyisocyanate compound is used as the cross-linking agent, addition of at least one publicly known catalyst such as dibutyltin dilaurate, tertiary amine and the like is shown as an example thereof.
Further, a silane base coupling agent, a titanium base coupling agent, a light blocking agent, a UV absorber, a stabilizing agent, a lubricant, a blocking inhibitor, an antioxidant and the like can be added, and compounds obtained by copolymerizing them with the resins described above can be used.

### Method for forming the weather resistant coating layer:

The weather resistant coating layer can be formed by suitably employing publicly known coating methods. For example, any of methods such as a reverse roll coater, a gravure coater, a rod coater, an air doctor coater, a coating method using a spray or a brush and the like can be used. After coating, the solvent can be evaporated by using a publicly known drying method including heat drying such as hot air drying at a temperature of 80 to 200°C and hot roll drying, infrared drying and the like. Also, cross-linking treatment carried out by irradiation with an electron beam can be carried out as well in order to enhance the moisture resistance and the durability.

A thickness of the weather resistant coating layer is 0.005 to 5 µm, preferably 0.01 to 1 µm. If the thickness is 5 µm or less as described above, the lubricity is good, and peeling of the weather resistant coating layer itself from the base material film by an internal stress is scarcely brought about. Also, if the thickness is 0.005 µm or more, the even thickness can be maintained, and it is preferred.
Further, flattening of a surface of the base material film by the weather resistant coating layer allows particles for forming the inorganic thin film layer to be accumulated minutely and makes it easy to form the layer in an even thickness, and therefore the high gas barriering property can be obtained.

### Inorganic thin film layer:

An inorganic substance constituting the inorganic thin film layer includes silicon, aluminum, magnesium, zinc, tin, nickel, titanium, carbon hydride and oxides, carbides, nitrides thereof and mixtures thereof, and it is preferably silicon oxide, aluminum oxide and diamond-like carbon comprising principally carbon hydride. In particular, silicon oxide, silicon nitride, silicon oxynitride and aluminum oxide are preferred in terms of enabling to maintain stably the high gas barriering property.

A material gas which can be used for chemical gas phase vapor deposition comprises preferably at least one kind of gas. In forming, for example, a silicon compound thin film, a first raw material gas containing silicon and a second raw material gas such as ammonia, nitrogen, oxygen, hydrogen and rare gas including argon are preferably used. Monosilane, tetramethoxysilane, methyltrimethoxysilane, dimethyldimethoxysilane, phenyltrimethoxysilane, diphenyldimethoxysilane, tetraethoxysilane, methyltriethoxysilane, dimethyldiethoxysilane, phenyltriethoxysilane, diphenyldiethoxysilane, hexyltrimethoxysilane, hexyltriethoxysilane, decyltrimethoxysilane, decyltriethoxysilane, trifluoropropyltrimethoxysilane, hexamethyldisiloxane, hexamethyldisilazane and the like can be used alone or in combination of two kinds thereof as the first raw material gas containing silicon. Also, the raw material gas may be either liquid or gas at room temperature, and the liquid raw material can be supplied into the apparatus by vaporizing by means of a raw material vaporizing equipment. In a catalytic chemical gas phase growing method, a monosilane gas is preferred in terms of deterioration, a reactivity and reaction rate of the heated catalyst.

Any of methods such as a vapor deposition method, a coating method and the like can be used as a method for forming the inorganic thin film layer of the gas barriering film, and the vapor deposition method is preferred in terms of obtaining the even thin film having a high gas barriering property. Methods such as physical vapor phase deposition (PVD) and chemical vapor phase deposition (CVD) are included in the above vapor deposition method. The physical vapor phase deposition method includes vacuum vapor deposition, ion plating, sputtering and the like, and the chemical vapor phase deposition method includes plasma CVD making use of plasma and a catalytic chemical gas phase growing method (Cat-CVD) in which a material gas is subjected to catalytic heat decomposition using a heated catalyst.

Further, the inorganic thin film layer is turned preferably into a multilayer in terms of enabling to maintain and secure stably the high gas barriering property over a long period of time under severe environment. In such case, various publicly known film forming methods may be combined. Included therein is, for example, a multilayer inorganic thin film constitution in which a vacuum vapor deposition film/a vacuum vapor deposition film, a vacuum vapor deposition film/a plasma CVD film, a vacuum vapor deposition film/plasma treatment/a vacuum vapor deposition film, a vacuum vapor deposition film/a plasma CVD film/a vacuum vapor deposition film, a vacuum vapor deposition film/a Cat-CVD film/a vacuum vapor deposition film, a vacuum vapor deposition film/a weather resistant coat/a vacuum vapor deposition film, a plasma CVD film/a vacuum vapor deposition film, a plasma CVD film/a vacuum vapor deposition film/a plasma CVD film or the like is formed in order on the weather resistant coating layer. Among them, a multilayer of a vacuum vapor deposition film/a plasma CVD film is preferred in terms of a good gas barriering property, an adhesive property and a productivity.

A thickness of each inorganic thin film layer is usually 0.1 to 500 nm, preferably 0.5 to 100 nm and more preferably 1 to 50 nm. If the thickness falls in the ranges described above, the sufficiently high gas barriering property is obtained, and the productivity is excellent without bringing about cracking and peeling on the inorganic thin film layer.

### Protective layer for the gas barriering layer:

A protective layer may be provided on the gas barriering layer in order to protect the inorganic thin film layer described above. Either of a solvent-soluble resin and a water-soluble resin can be used as a resin for forming the above protective layer, and to be specific, polyester base resins, urethane base resins, acryl base resins, polyvinyl alcohol base resins, ethylene vinyl alcohol base resins, vinyl-modified resins, nitrocellulose base resins, silicone base resins, isocyanate base resins, epoxy base resins, oxazoline group-containing resins, modified styrene base resins, modified silicone base resins, alkyl titanate and the like can be used alone or in combination of two or more kinds thereof. Further, a layer obtained by mixing at least one kind of inorganic particles selected from a silica sol, an alumina sol, a particulate inorganic filler and a stratiform inorganic filler with at least one kind of the resins described above in order to improve a barriering property, a frictional property and a lubricity or a layer comprising an inorganic particle-containing resin formed by polymerizing a raw material of the resin described above under the presence of the above inorganic particles can be used as the protective layer.

The resin for forming the protective layer is preferably the water-soluble resin described above in terms of enhancing a gas barriering property of the inorganic thin film layer. Further, the water-soluble resin is preferably a vinyl alcohol base resin or an ethylene vinyl alcohol resin.
Further, a resin layer prepared by coating an aqueous solution containing polyvinyl alcohol and an ethylene · unsaturated carboxylic acid copolymer can be used as the protective layer.

A thickness of the protective layer is preferably 0.05 to 10 µm, more preferably 0.1 to 3 µm in terms of the printing property and the processability. Publicly known coating methods are suitably selected as a forming method therefor. For example, any of methods such as a reverse roll coater, a gravure coater, a rod coater, an air doctor coater, a coating method using a spray or a brush and the like can be used. Also, it may be carried out by dipping the deposited film in a resin solution for the protective layer. After coating, moisture can be evaporated by using a publicly known drying method including heat drying such as hot air drying at a temperature, of 80 to 200°C and hot roll drying, infrared drying and the like. Also, cross-linking treatment carried out by irradiation with an electron beam can be carried out as well in order to enhance the moisture resistance and the durability.

### Gas barriering layer:

The gas barriering layer is used preferably in the form of a gas barriering film, and for example, the gas barriering film prepared by providing the weather resistant coating layer, the inorganic thin film layer and, if necessary, the protective layer on the base material film is more preferred.
In the present invention, 2 to 8 layers of the above gas barriering layer are preferably laminated in order to enhance a gas barriering property of the back sheet for a solar battery and maintain it ower a long period of time under severe environment, and 2 to 4 layers thereof are more preferably laminated. The constitutions of the respective gas barriering layers used for lamination may be the same or different and can be used in suitable combinations according to the specifications of the back sheet, such as a gas barriering performance, a thickness and the like.
Further, the gas barriering layer can be subjected to heat treatment at 60°C or higher for 24 hours or longer after forming the inorganic thin film layer and/or forming the protective layer and/or laminating the plural gas barriering films. The above heat treatment makes it possible to enhance and stabilize the gas barriering property.
A thickness of the whole gas barriering layers is preferably 5 to 150 µm, more preferably 10 to 100 µm in terms of the gas barriering property and the long term stability thereof.

### <Other films>

In the back sheet for a solar battery according to the present invention, a dielectric breakdown voltage of 1 kV or more in terms of a voltage resistant characteristic is desirably satisfied. In the above case, a whole thickness of the back sheet has to be about 200 µm or more and 250 µm or more.
When any or each thickness of the light shielding colored layer, the gas barriering layer and the weather resistant polyester base resin layer is small, the back sheet can endure a dielectric breakdown voltage of 1 kV, and other plastic films can be laminated between the respective layers in order to provide them with a satisfactory mechanical strength, a satisfactory flame retardant property and the like.
Capable of being used as the above other layers are, for example, those optionally selected from publicly known films or sheets of low density polyethylene, middle density polyethylene, high density polyethylene, linear low density polyethylene, polypropylene, ethylene-propylene copolymers, ethylene-vinyl acetate copolymers or saponified products thereof, ionomer resins, ethylene-ethyl acrylate copolymers, ethylene-acrylic acid or methacrylic acid copolymers, polymethylpentene base resins, polyester base resins, polybutene base resins, polyvinyl chloride base resins, polyvinyl acetate base resins, polyvinylidene chloride base resins, polyvinyl chloride-polyvinylidene chloride copolymers, poly(meth)acryl base resins, polyacrylonitrile base resins, polystyrene base resins, acrylonitrile-styrene copolymers (AS base resins), acrylonitrile-butadiene-styrene copolymers (ABS base resins), polyester base resins, polyamide base resins, polycarbonate base resins, polyvinyl alcohol base resins or saponified products thereof, fluorine base resins, diene base resins, polyacetal base resins, polyurethane base resins, nitrocellulose and the like. In the present invention, films or sheets comprising polyester base resins, fluorine base resins, polypropylene base resins and cyclic polyolefin base resins are preferred from the viewpoints of a heat resistance, a strength, a weatherability, a gas barriering property and the like.
A constitution in which in the back sheet prepared by laminating in order the light shielding colored layer, the gas barriering layer and the weather resistant polyester base resin layer each having the contents described above, the polyester base resin film is allowed to further intervene between the light shielding colored layer and the other layers is shown as one example of the layer constitution described above.

### <Adhesive>

In the back sheet for a solar battery according to the present invention, the light shielding colored layer, the gas barriering layer and the weather resistant polyester base resin layer each described above and, if necessary, a readily-adhesive layer and other films can be laminated respectively by methods such as dry lamination and the like. When an adhesive is used in the lamination, the kind of the adhesive which can be used includes, for example, Polyvinyl acetate base adhesives, polyacrylic acid ester base adhesives comprising homopolymers of ethyl, butyl or 2-ethylhexyl ester of acrylic acid or copolymers of the esters described above with methyl methacrylate, acrylonitrile, styrene and the like, cyanoacrylate base adhesives, ethylene copolymer base adhesives comprising copolymers of ethylene with monomers such as vinyl acetate, ethyl acetate, acrylic acid, methacrylic acid and the like, polyolefin base adhesives comprising polyethylene base resins or polypropylene base resins, cellulose base adhesives, polyester base adhesives, polyether base adhesives, polyamide base adhesives, polyimide base adhesives, amino resin base adhesives comprising urea resins or melamine resins, phenol resin base adhesives, epoxy resin base adhesives, polyurethane base adhesives, reactive (meth)acryl base adhesives, rubber base adhesives comprising chloroprene rubber, nitrile rubber, styrene-butadiene rubber, styrene-isoprene rubber and the like and silicone base adhesives.

Among them, preferred in terms of a hydrolytic resistance are adhesive compositions prepared by blending 1 to 50 parts by mass of at least one compound selected from carbodiimide compounds, oxazoline compounds and epoxy compounds with 100 parts by mass of a single substance of either polyesterpolyol or polyesterurethanepolyol subjected to chain extension by a difunctional or more isocyanate compound or a mixture thereof and/or a single substance of either polycarbonatepolyol or polycarbonateurethanepolyol subjected to chain extension by a difunctional or more isocyanate compound or a mixture thereof and/or a composition prepared by blending acrylpolyol in which a hydroxyl group is introduced into a side chain with a cross-linking agent.

The polyesterpolyol described above can be obtained by using at least one of aliphatic acids such as succinic acid, glutaric acid, adipic acid, pimelic acid, suberic acid, azelaic acid, sebacic acid, brassilic acid and the like and aromatic dibasic acids such as isophthalic acid, terephthalic acid, naphthalenedicarboxylic acid and the like and at least one of aliphatic diols such as ethylene glycol, propylene glycol, butanediol, neopentyl glycol, methylpentanediol, hexanediol, heptanediol, octanediol, nonanediol, decanediol, dodecanediol and the like, alicyclic diols such as cyclohexanediol, hydrogenated xylylene glycol and the like and aromatic diols such as xylylene glycol and the like.
Further, it includes polyesterurethanepolyol obtained by subjecting hydroxyl groups at both ends of the above polyesterpolyols to chain extension with a single substance of an isocyanate compound selected from, for example, 2,4- or 2,6-tolylenediisocyanate, xylylenediisocyanate, 4,4'-diphenylmethanediisocyanate, methylenediisocyanate, isopropylenediisocyanate, lisinediisocyanate, 2,2,4- or 2,4,4-trimethylhexamethylenediisocyanate, 1,6-hexamethylenediisocyanate, methylcyclohexanediisocyanate, isophoronediisocyanate, 4,4'-dicyclohexylmethanediisocyanate, isopropylidenedicyclohexyl-4,4'-diisocyanate and the like or an adduct body, a buret body an isocyanurate, body comprising at least one selected from the above isocyanate compounds.
The isocyanate compounds described above can be used as the cross-linking agent for cross-linking the polyesterpolyols, and it shall not be restricted to them and is irrespective of the kind as long as they are cross-linking agents having a reactivity with an active hydrogen group.

The carbodiimide compound blended in order to block a carboxyl group produced when various polyols are hydrolyzed under accelerating environment at high temperature and high humidity includes N,N'-di-o-toluylcarbodiimide, N,N'-diphenylcarbodiimide, N,N'-di-2,6-dimethylphenylcarbodiimide, N,N'-bis(2,6-diisopropylphenyl)carbodiimide, N,N-dioctyldecylcarbodiimide, N-toluyl-N'-cyclohexylcarbodiimide, N,N.di-2,2-di-tert-butylphenylcarbodiimide, N-toluyl-N'-phenylcarbodiimide, N-N'-di-p-nitrophenylcarbodiimide, N,N'-di-p-aminophenylcarbodiimide, N,N'-di-p-hydroxyphenylcarbodiimide, N,N'-di-cyclohexylearbodiimide, N,N-di-p-toluylearbodiimide and the like.

The oxazoline compound having the same function includes monoxazoline compounds such as 2-oxazoline, 2-methyl-2-oxazoline, 2-phenyl-2-oxazoline, 2,5-diphenyl-2-oxazoline, 2,4-di phenyl-2-oxazoline and the like and dioxazoline compounds such as 2,2'-(1,3-phenylene)-bis(2-oxazoline), 2,2'-(1,2-ethylene)-bis(2-oxazoline), 2,2'-(1,4-butylene)-bis(2-oxazoline), 2,2'-(1,4-phenylene)-bis(2-oxazoline) and the like.

Similarly, the epoxy compound includes diglycidyl ethers of aliphatic diols such as 1,6-hexanediol, neopentyl glycol, polyalkylene glycol and the like, polyglycidyl ethers of aliphatic polyols such as sorbitol, sorbitan, polyglycerol, pentaerythritol, diglycerol, glycerol, trimethylolpropane and the like, polyglycidyl ethers of alicyclic polyols such as cyclohexanedimethanol and the like, diglycidyl esters or polyglycidyl esters of aliphatic and aromatic polyvalent carboxylic acids such as terephthalic acid, isophthalic acid, naphthalenedicarboxylic acid, trimellitic acid, adipic acid, sebacic acid and the like, diglycidyl ethers or polyglycidyl ethers of polyhydric phenols such as resorcinol, bis-(p-hydroxyphenyl)methane, 2,2-bis-(p-hydroxyphenyl)propane, tris(p-hydroxyphenyl)methane, 1,1,2,2-tetrakis(p-hydroxyphenyl)ethane and the like, N-glycidyl derivatives of amines such as N,N-diglycidylaniline, N,N-diglycidyltoluidine, N,N,N,N-tetraglycidyl-bis-(p-aminophenyl)methane and the like, triglycidyl derivatives of aminophenol, triglycidyl tris(2-hydroxyethyl)isocyanurate, triglycidyl isocyanurate, orthocresol type epoxy and phenol novolac type epoxy.

The carbodiimide compound, the oxazoline compound and the epoxy compound which are blended with the adhesive are blended preferably in an amount of 1 to 50 parts by mass based on 100 parts by mass of a composition prepared by blending various polyols with the cross-linking agent in terms of a hydrolytic resistance, an adhesive property and a coating workability of the adhesive layer.

Further, a compound bringing about cross-linking reaction starting from a hydroxyl group produced by hydrolysis may be blended. The above compound includes phosphorus base compounds, and capable of being used are tris(2,4-di-t-butylphenyl) phosphite, tetrakis(2,4-di-t-butylphenyl) 4,4'-biphenylenephosphonite, bis(2,4-di-t-butylphenyl) pentaerythritol-di-phosphite, bis(2,6-di-t-butyl-4-methylphenyl) pentaerythritol-di-phosphite, 2,2-methylenebis(4,6-di-t-butylphenyl)octyl phosphite, 4,4'-butylidene-bis(3-methyl-6-t-butylphenyl-di-tridecyl) phosphite, 1,1,3-tris(2-methyl-4-ditridecylphosphite-5-t-butylphenyl)butane, tris(mixed mono- and di-nonylphenyl) phosphite, tris(nonylphenyl) phosphite, 4,4'-isopropylidenebis(phenyl-dialkylphosphite) and the like. However, since it is more essential in terms of inhibiting hydrolysis of the polyester compound to block a carboxyl group functioning as a catalyst than to cross-link further a hydroxyl group once produced by hydrolysis with the phosphorus compound, the carbodiimide compound, the oxazoline compound and the epoxy compound each described above are preferred, and the most preferred compound includes the carbodiimide compound.

The polycarbonatepolyol can be obtained by reacting, for example, a carbonate compound with diol. Dimethyl carbonate, diphenyl carbonate, ethylene carbonate and the like can be used as the carbonate compound. Capable of being used are polycarbonatepolyols obtained by using as the diol, a mixture of at least one of aliphatic diols such as ethylene glycol, propylene glycol, butanediol, neopentyl glycol, methylpentanediol, hexanediol, heptanediol, octanediol, nonanediol, decanediol, dodecanediol and the like, alicyclic diols such as cyclohexanediol, hydrogenated xylylene glycol and the like and aromatic diols such as xylylene glycol and the like, or polycarbonateurethanepolyols subjected to chain extension with the isocyanates compound described above. In particular, the aliphatic polycarbonatepolyols are preferably used considering the performances of the adhesive.

Used as the acryl polyol are polymers comprising essential components of hydroxyl group-containing monomers such as 2-hydroxyethyl (meth)acrylate, 2-hydroxypropyl (meth)acrylate and the like and principal components of (meth)acrylic acid and alkyl (meth)acrylate base monomers having an allyl group such as methyl, ethyl, n-propyl, i-propyl, n-butyl, i-butyl, t-butyl, 2-ethylhexyl and cyclohexyl, and capable of being further used are copolymers obtained by copolymerizing amide group-containing monomers such as (meth)acrylamide, N-alkyl(meth)acrylamide, N,N-dialkyl(meth)acrylamide (the alkyl group includes methyl, ethyl, n-propyl, i-propyl, n-butyl, i-butyl, t-butyl, 2-ethylhexyl, cyclohexyl and the like), N-alkoxy(meth)acrylamide, N,N-dialkoxy(meth)acrylamide (the alkoxy group includes methoxy, ethoxy, butoxy, isobutoxy and the like), N-methylol(meth)acrylamide, N-phenyl(meth)acrylamide and the like and glycidyl group-containing monomers such as glycidyl(meth)acrylamide, allyl glycidyl ether and the like. Further, capable of being used are copolymers obtained by copolymerizing monomers such as vinyl isocyanate, allyl isocyanate, styrene, α -methylstyrene, vinyl methyl ether, vinyl ethyl ether, maleic acid, alkyl maleic acid monoesters, fumaric acid, alkyl fumaric acid monoesters, itaconic acid, alkyl itaconic acid monoesters, (meth)acrylonitrile, vinylidene chloride, ethylene, propylene, vinyl chloride, vinyl acetate, butadiene and the like.

Additives such as a UV absorber, a light stabilizer, an inorganic filler, a colorant and the like can be added to the adhesive as long as an influence is not exerted on an adhesive force.
Also, an adhesive layer can be formed by coating the adhesive described above by a publicly known coating method such as roll coating, gravure coating, kiss coating and the like.
A coating amount is preferably 0.1 to 15 g/m² in terms of a dried film thickness.

### <black sheet for solar battery>

The back sheet for a solar battery according to the present invention comprises an essential constitution of the light shielding colored layer, the weather resistant polyester base resin layer and the gas barriering layer provided between the above layers, and to be specific, the following constitution is preferably employed.
(A) A film comprising the light shielding colored layer/a film comprising the gas barriering layer containing the weather resistant coating layer and the inorganic thin film layer/a film comprising the weather resistant polyester base resin layer.
(B) A film comprising the light shielding colored layer and the gas barriering layer containing the weather resistant coating layer and the inorganic thin film layer/a film comprising the weather resistant polyester base resin layer.
(C) A film comprising the light shielding colored layer/a film comprising the gas barriering layer containing the weather resistant coating layer and the inorganic thin film layer and the weather resistant polyester base resin layer.

In the film comprising the light shielding colored layer and the gas barriering layer containing the weather resistant coating layer and the inorganic thin film layer in the constitution (B) described above, the base material of the gas barriering layer doubles as the light shielding colored layer, and the gas barriering layer has to be provided at a side of the film comprising the weather resistant polyester base resin layer. In this case, a thickness of the above film is preferably 20 to 300 µm, more preferably 50 to 250 µm,

In the film comprising the gas barriering layer containing the weather resistant coating layer and the inorganic thin film layer and the weather resistant polyester base resin layer in the constitution (C) described above, the base material of the gas barriering layer doubles as the weather resistant polyester base resin layer, and the gas barriering layer has to be provided at a side of the film comprising the light shielding colored layer. In this case, a thickness of the above film is preferably 10 to 300 µm, more preferably 20 to 200 µm. In the constitutions of (A) to (C) described above, the respective layers can be laminated by a method such as dry lamination and the like.
Capable of being used is the back sheet in which the readily-adhesive layer described above is further provided, if necessary, at an outside face of the light shielding colored layer, that is, a side brought into contact with the filler at a back face side of the light shielding colored layer in the constitutions of (A) to (C) described above.

A thickness of the back sheet for a solar battery according to the present invention is 50 to 750 µm, preferably 100 to 500 µm and more preferably 200 to 400 µm in terms of a strength, a durability, a voltage resistance and a cost.
When the light shielding colored layer is a white film, a whiteness degree of the back sheet is measured by a hunter method, JIS L1015, and a value thereof is preferably 75 % or more, more preferably 80 % or more in terms of enhancing a power generation efficiency of the solar battery.
A water vapor transmission rate of the back sheet for a solar battery after stored at 85°C and 85 RH % for 1000 hours is preferably 1.0 g/m²/day or less, more preferably 0.8 g/m²/day or less. Further, a water vapor transmission rate of the back sheet for a solar battery after stored at 85°C and 85 RH % for 300 hours is preferably 2.0 g/m²/day or less, more preferably 1.0 g/m²/day or less.
A shrinkage rate of the back sheet for a solar battery in heating at 150°C for 30 minutes is preferably 3 % or less, more preferably 1 % or less and further preferably 0.5 % or less. If the shrinkage rate is high, inferior lamination is brought about in heating and pressing in a lamination step of preparing the solar battery module.

### <Solar battery module>

The present invention relates to the solar battery module comprising the back sheet of the present invention.
In the solar battery module of the present invention, a transparent substrate, a filler, a solar battery device, a filler and the above back sheet for a solar battery are laminated in order from a sunlight receiving side.
Glass or a sheet and/or a film of a plastic are used as the transparent substrate. When it is a plastic, for the purpose of providing it with a gas barriering property, an inorganic thin film can be formed thereon in the same manner as in the gas barriering film constituting the above back sheet for a solar battery. For the purpose of improving the heat resistance, the weather-ability, the mechanical strength, the electrification, the dimensional stability and the like, a cross-linking agent, an antioxidant, a light stabilizer, a UV absorber, an antistatic agent, reinforcing fibers, a flame retardant, an antiseptic agent and the like can be added thereto, and various sheets and/or films can be laminated thereon. A thickness of the transparent substrate can suitably be set in terms of a strength, a gas barriering property, a durability and the like.

Various resins having in combination a light transmitting property, a shock absorbing property and an adhesive property with the transparent substrate, the solar battery device and the back sheet for a solar battery can be used for the filler. They include, for example, fluorine base resins, ethylene-vinyl acetate copolymers, ionomer resins, unsaturated carboxylic acid-modified polyolefin base resins, polyvinylbutyral base resins, silicone base resins, epoxy base resins, acryl base resins and the like. Further, a cross-linking agent, an antioxidant, a light stabilizer, a UV absorber and the like can be added to the filler layer. A thickness thereof can suitably be set according to the required physical properties.
The solar battery device is arranged and wired between the fillers. It includes, for example, a monocrystalline silicon type, a polycrystalline silicon type, an amorphous silicon type, a various compound semiconductor type, a dye sensitizing type, an organic thin film type and the like.

A method for producing the solar battery device shall not specifically be restricted and includes usually a step of laminating the transparent substrate, the filler, the solar battery device, the filler and the back sheet for a solar battery in this order and a step of aspirating them under vacuum and heating and pressing them.
The solar battery device is excellent in a weatherability and a durability because of an excellent weatherability and an excellent long term gas barriering property of the back sheet for a solar battery and is low in a cost and a weight, and therefore it can suitably be used for various applications regardless of small-sized, large-sized, indoor and outdoor applications.

### EXAMPLES

Next, the present invention shall more specifically be explained with reference to examples, but the present invention shall by no means be restricted by these examples.
The performances of the back sheets for a solar battery obtained in the respective examples were evaluated in the following manners.

### <Composition ratio of inorganic thin film>

An elemental composition of the inorganic thin film of the gas barriering film obtained was analyzed by means of ESCA-3400 manufactured by Shimadzu Corporation.

### <Thickness of inorganic thin film>

The gas barriering film obtained was embedded in a resin, and an ultrathin section was prepared in a cross-sectional direction thereof and observed under a transmission type electron microscope.

### <Adhesive property (peeling test) of constitutional layers>

A glass plate, an ethylene-vinyl acetate copolymer (EVA) sheet ("Solar Ever SC4", manufactured by Mitsui Chemicals Fabro, Inc.) and the back sheet for a solar battery prepared were superposed and subjected to vacuum pressing at 150°C for 15 minutes in a form in which a peeling film is interposed between the EVA sheet and the back sheet in a central part thereof to integrate them. Further, the glass plate, the EVA sheet and the back sheet for a solar battery were heated at 150°C for 30 minutes. After storing them at 85°C and 85 RH % for 1000 hours and 3000 hours, the back sheet corresponding to an area part of the peeling film was cut out, and a strip having a width of 15 mm was cut out from it and subjected to T type peeling at a speed of 100 mm/minute by means of a peeling test equipment ("EZ-TEST", manufactured by Shimadzu Corporation) to evaluate a peeking state thereof based on the following criteria.
○: impossible to peel
×: peeled in the gas barriering film

### <Water vapor transmission rate (WTR) (g/m²/day)>

A glass plate, the ethylene-vinyl acetate copolymer (EVA) sheet ("Solar Ever SC4", manufactured by Mitsui Chemicals Fabro, Inc.) and the back sheet for a solar battery prepared were superposed and subjected to vacuum pressing at 150°C for 15 minutes in a form in which a peeling film is interposed between the EVA sheet and the back sheet in a central part thereof to integrate them. Further, the glass plate/the EVA sheet/the back sheet for a solar battery was heated at 150°C for 30 minutes. After storing them at 85°C and 85 RH % for 1000 hours and 3000 hours, the back sheet corresponding to an area part of the peeling film was cut out and dried in air at room temperature for 2 days, and a water vapor transmission rate thereof was measured on the conditions of 40°C and 90 RH % by means of a water vapor transmission rate equipment (Model 17002, (manufactured by Illinois Instruments Inc.).

### <EVA adhesive property>

A glass plate, the ethylene-vinyl acetate copolymer (EVA) sheet ("Solar Ever SC4", manufactured by Mitsui Chemicals Fabro, Inc.) and the back sheet for a solar battery prepared were superposed and subjected to vacuum pressing at 150°C for 15 minutes to integrate them. Further, after the glass plate/the EVA sheet/the back sheet for a solar battery was heated at 150°C for 30 minutes and stored at 85°C and 85 RH % for 1000 hours and 3000 hours, it was cut out in a width of 15 mm, and an adhesive state thereof with the EVA sheet in 90 degree peeling carried out by an autograph was evaluated on the following criteria.
⊚: Peeling strength: 2000 g/15 mm or more
○: Peeling strength: 300 g/15 mm or more and less than 2000 g/15 mm
×: Peeling strength: less than 300 g/15 mm

### <Whiteness degree>

A whiteness degree of the back sheet for a solar battery prepared was measured with the white film turned to a light receiving side by a Hunter method according to JIS L1015.

### Example 1

First, a light shielding colored film (white film), a gas barriering film and a weather resistant film were prepared respectively by methods shown below, and then they were laminated to prepare a back sheet for a solar battery.

### <Preparation of light shielding colored film>

A polyethylene terephthalate resin (Novapecs, manufactured by Mitsubishi Chemical Corporation) having an oligomer amount of 0.5 % by mass as a raw material and precipitated barium sulfate (D50 = about 0.60 µm, manufactured by Tokan Material Technology Co., Ltd.) as a white pigment were used and molten and mixed sufficiently evenly in an extruding equipment by a master batch method to extrude a non-stretched sheet containing 15 % by mass of barium sulfate on a cast roll, and then the sheet was stretched in a 3.5 times ratio at 95°C in a longitudinal direction and then stretched in a 4.0 times ratio at 135°C in a lateral direction to prepare a biaxially stretched white polyethylene terephthalate film (white film) having a thickness of 150 µm.

### <Preparation of readily-adhesive layer>

A surface of the light shielding colored film described above was subjected to corona treatment, and "Yuriano U302" manufactured by Arakawa Chemical Industries, Ltd. was coated on one surface thereof in a thickness of 3 µm to prepare a readily-adhesive layer on one surface of the light shielding colored (white) film.

### <Preparation of gas barriering film>

A biaxially stretched polyethylene terephthalate film ("H100C12" manufactured by Mitsubishi Plastics, Inc.) having a thickness of 12 µm was used as a substrate film to subject one surface thereof to corona treatment, and a coating liquid prepared by mixing "Placcel 205" manufactured by Daicel Chemical Industries, Ltd. as polycaprolactonediol and "Denacol EX252" manufactured by Nagase Chemtex Corporation as an epoxy resin so that an equivalent proportion of an epoxy group to a hydroxy group was 1:2 was coated thereon by a gravure coating method and dried to form a weather resistant coating layer having a thickness of 0.1 µm.
Then, SiO was vaporized by a high frequency heating method under vacuum of 1 × 10⁻⁵ Torr by means of a vacuum vapor deposition equipment to obtain a gas barriering film having a SiOₓ (x = 1.7) thin firm having a thickness of 20 nm on the coating layer.

### <Weather resistant polyester base resin films>

A polyethylene naphthalate film ("Q65F" manufactured by Teijin DuPont Films Japan Ltd.) having a thickness of 50 µm was used to subject one surface thereof to corona treatment

### <Lamination of respective films>

An adhesive 10 g/m² was coated on a corona-treated surface side of the polyethylene naphthalate film described above by a gravure coating method, and it was stuck on a surface of the gas barriering fillm at an inorganic thin film side and reeled. Then, the adhesive 10 g/m² was coated in the same manner on a surface of the light shielding colored (white) film on which the readily-adhesive layer was not provided, and it was stuck on a polyethylene terephthalate film surface side of the gas barriering film on which the polyethylene naphthalate film was stuck.
A mixture of "AD-76P1" and "CAT-10L" each manufactured by Toyo-Morton, Ltd. was used as the adhesive in both cases.

### Example 2

A gas barriering film was obtained in the same manner as in Example 1 to prepare a back sheet for a solar battery, except that the coating liquid for the gas barriering film was changed to the following one.

### Coating liquid:

"Placcel 220" manufactured by Daicel Chemical Industries, Ltd. used as polycaprolactonediol and "Sumijul N-3200" manufactured by Sumika Bayer Urethane Co., Ltd. used as an isocyanate resin were mixed so that an equivalent proportion of an isocyanate group to a hydroxy group was 1:1 to prepare a coating liquid.

### Example 3

A gas barriering film was obtained in the same manner as in Example 1 to prepare a back sheet for a solar battery, except that the coating liquid for the gas barriering film was changed to the following one.

### Coating liquid:

"Nippollan 982R" manufactured by Nippon Polyurethane Industry Co., Ltd. used gas polycarbonatediol and "Coronate L" manufactured by Nippon Polyurethane Industry Co., Ltd. used as an isocyanate resin were mixed so that an equivalent proportion of an isocyanate group to a hydroxy group was 1:1 to prepare a coating liquid.

### Example 4

A gas barriering film was obtained in the same manner as in Example 1 to prepare a back sheet for a solar battery, except that the coating liquid for the gas barriering film was changed to the following one.

### Coating liquid:

"Placed CD CD210" manufactured by Daicel Chemical Industries, Ltd. used as polycarbonatediol and "Takenate D-170HN" manufactured by Mitsui Chemicals Polyurethane, Inc. used as an isocyanate resin were mixed so that an equivalent proportion of an isocyanate group to a hydroxy group was 1 : 1 to prepare a coating liquid.

### Example 5

A gas barriering film was obtained in the same manner as in Example 1 to prepare a back sheet for a solar battery, except that the coating liquid for the gas barriering film was changed to the following one.

### Coating liquid:

"S-LEC BL-1 (butyral degree: 63 ± 3 mol %)" manufactured by Sekisui Chemical Cho., Ltd. used as a polyvinylbutyral resin and an epoxy resin ("Denacol EX252" manufactured by Nagase Chemtex Corporation) used as a cross-linking agent were mixed so that an equivalent proportion of an epoxy group to a hydroxy group was 1:1 to prepare a coating liquid.

### Example 6

A gas barriering film was obtained in the same manner as in Example 1 to prepare a back sheet for a solar battery, except that the coating liquid for the gas barriering film was changed to the following one.

### Coating liquid:

A polyvinyl alcohol resin "Poval PVA-117" (saponification degree: 98.0 to 99.0 mol %, polymerization degree: 1700) 250 g manufactured by Kuraray Co., Ltd. was added to 2400 g of ion-exchanged water and dissolved by heating to prepare an aqueous solution, and 18 g of 35 % hydrochloric acid was added to the aqueous solution. Butylaldehyde 140 g was dropwise added thereto while stirring at 15°C to precipitate resin particles. Then, the temperature was elevated up to 50°C while dropwise adding thereto 150 g of 35 % hydrochloric acid under stirring, and the mixture was maintained for 2 hours. Thereafter, the liquid was cooled down and neutralized by sodium hydrogencarbonate, and the resin particles were washed with water and dried to obtain a polyvinylbutyral resin powder (butyral degree: 70 mol %, isotactic triad type residual hydroxyl group amount: 0.1 mol %), followed by dissolving it in a 4 : 6 mixed solvent of ethanol and toluene to prepare a resin solution. Further, the isocyanate resin "Sumijul N-3200" manufactured by Sumika Bayer Urethane Co., Ltd. was used as a cross-linking agent, and the polyvinylbutyral resin solution and the isocyanate resin were mixed so that an equivalent of an isocyanate group to a hydroxy group was 1:1 to prepare a coating liquid.

### Example 7

A gas barriering film was obtained in the same manner as in Example 1 to prepare a back sheet for a solar battery, except that the coating liquid for the gas barriering film was changed to the following one.

### Coating liquid:

A polyvinyl alcohol resin "GOHSENOL" (saponification degree: 97.0 to 98.8 mol %, polymerization degree: 2400) 220 g manufactured by Nippon Gohsei. was added to 2810 g of ion-exchanged water and dissolved by heating to prepare an aqueous solution, and 645 g of 35 % hydrochloric acid was added to the aqueous solution while stirring at 20°C. Then, 3.6 g of butylaldehyde was added thereto at 10°C while stirring, and after 5 minutes, 143 g of acetaldehyde was added thereto while stirring to precipitate resin particles. Next, after the liquid was maintained at 60° C for 2 hours, it was cooled down and neutralized by sodium hydrogencarbonate, and the resin particles were washed with water and dried to obtain a polyvinylacetacetal resin powder (acetal degree: 75 mol %), followed by dissolving it in a 4 : 6 mixed solvent of ethanol and toluene to prepare a resin solution. Then, the isocyanate resin "Sumijul N-3200" manufactured by Sumika Bayer Urethane Co., Ltd. was used as a cross-linking agent, and the polyvinylacetacetal resin solution and the isocyanate resin were mixed so that an equivalent of an isocyanate group to a hydroxy group was 1 : 1 to prepare a coating liquid.

### Example 8

A gas barriering film was obtained in the same manner as in Example 1 to prepare a back sheet for a solar battery, except that the coating liquid for the gas barriering film was changed to the following one.

### Coating liquid:

A four neck flask equipped with a stirrer, a thermometer, a cooling device and a nitrogen-introducing tube was charged with 100 parts by mass of ethyl acetate under nitrogen flow and heated up to 80°C. Then, a mixture of a raw material comprising polymerizable monomer components shown in a blend table (Table 1) and 1 part by mass of benzoyl peroxide was dropwise added thereto in 2 hours and maintained at 80°C for 4 hours to obtain a 50 mass % solution of an acryl base copolymer.
Then, an epoxy base copolymer ("Denacol EX622" manufactured by Nagase Chemtex Corporation) was mixed with the above acryl base resin solution so that an equivalent ratio of an epoxy group to a carboxyl group was 1 : 1 to prepare a coating liquid.

### Examples 9 to 18

Gas barriering films were obtained in the same manner to prepare back sheets for a solar battery, except that in Example 8, raw materials comprising polymerizable monomer components shown in Table 1 were used to prepare acryl base copolymer solutions, and then the isocyanate resin ("Sumijul N-3200" manufactured by Sumika Bayer Urethane Co., Ltd.) was mixed with the above acryl base resin solutions so that an equivalent proportion of an isocyanate group to a hydroxy group was 1 : 1.

### Example 19

A gas barriering film was obtained in the same manner to prepare a back sheet for a solar battery, except that in Example 8, a raw material comprising polymerizable monomer components shown in Table 1 was used to prepare an acryl base copolymer solution.

**Table 1**

| | | | Example | | | | | | | | | | | |
|---|---|---|---|---|---|---|---|---|---|---|---|---|---|---|
| | | | 8 | 9 | 10 | 11 | 12 | 13 | 14 | 15 | 16 | 17 | 16 | 19 |
| Acryl base copolymer raw material | Polymerizable UV ray | kind | a-1 | a-2 | a-2 | a-1 | a-1 | | a-1 | | a-1 | a-1 | a-3 | a-2 |
| | stabilizing monomer | was part | 5.0 | 5.0 | 2.0 | 3.0 | 0.5 | 0.0 | 1.0 | 0.0 | 3.0 | 2.0 | 2.0 | 5.0 |
| | Polymerizable UV ray | kind | | | b-1 | b-2 | | | b-2 | b-2 | b-3 | b-2 | b-3 | b-1 |
| | absorbing monomer | mass part | 0.0 | 0.0 | 4.0 | 1.0 | 0.0 | 0.0 | 0.5 | 30.0 | 50.0 | 35.0 | 20.0 | 10.0 |
| | | kind | c-1 | c-1 | c-1 | c-1 | c-1 | c-1 | c-1 | c-1 | | c-1 | c-1 | c-1 |
| | Cycloalkyl | mass part | 40.0 | 30.0 | 30.0 | 40.0 | 30.0 | 30.0 | 30.0 | 30.0 | 0.0 | 30.0 | 50.0 | 30.0 |
| | (meth)acrylate | kind | | c-2 | c-2 | | | | | | | | | c-2 |
| | | mass part | | 26.0 | 25.0 | | | | | | | | | 25.0 |
| | Polymerizable | | | | | | | | | | | | | |
| | unsaturated | kind | d-1 | d-2 | d-2 | d-2 | d-2 | d-2 | d-2 | d-2 | d-2 | d-2 | d-2 | |
| | monomer having | mass part | 10.0 | 18.0 | 19.0 | 5.0 | 10.0 | 10.0 | 2.0 | 10.0 | 10.0 | 5.0 | 5.0 | |
| | hydroxyl group | | | | | | | | | | | | | |
| | | kind | e-1 | | | e-1 | e-1 | e-1 | e-1 | e-3 | e-3 | | | |
| | Polymerizable | mass part | 20.0 | | | 20.0 | 20.0 | 20.0 | 26.0 | 30.0 | 32.0 | | | |
| | unsaturated | kind | e-2 | e-2 | e-2 | e-2 | e-2 | e-2 | e-2 | | e-4 | e-2 | e-2 | e-2 |
| | monomer | mass part | 24.0 | 20.0 | 20.0 | 30.5 | 39.0 | 39.5 | 40.0 | | 5.0 | 28.0 | 23.0 | 29.0 |
| | | kind | e-6 | e-6 | e-6 | e-6 | e-6 | e-6 | e-6 | | | | | e-6 |
| | | mass part | 1.0 | 1.0 | 1.0 | 0.5 | 0.5 | 0.5 | 0.5 | 0.0 | 0.0 | 0.0 | 0.0 | 1.0 |
| cross-linking compound | | | A | B | B | B | B | B | B | B | B | B | B | |

| | | | | | | | | | | | | | | |
|---|---|---|---|---|---|---|---|---|---|---|---|---|---|---|
| A: epoxy B: isocyanate | | | | | | | | | | | | | | |

The following monomers were used in the examples described above. Polymerizable UV ray stabilizing monomers:
a-1: 4-methacryloyloxy-2,2,6,6-tetramethylpiperide
a-2: 4-methacryloyloxy-2,2,6,6-pentamethylpiperidine
a-3: 1-methacryloyl-4-methacryloylamino-2,2,6,6-tetramethylpiperidine

Polymerizable UV ray absorbing monomers:
b-1: 2-hydroxy-4-(3-methacryloyloxy-2-hydroxypropoxy)-benzophenone
b-2: 2-[2'-hydroxy-5'-(methacryloyloxyethyl)phenyl]-2H-benzotriazole
b-3: 2-[2'-hydroxy-5'-(β-methacryloyloxyethoxy)-3'-t-butylphenyl]-4-t-butyl-2H-benzotriazole
Cycloalkyl (meth)acrylates:
c-1: cyclohexyl methacrylate
c-2: t-butylcyclohexyl methacrylate
Polymerizable unsaturated monomers having a hydroxyl group:
d-1: hydroxypropyl acrylate
d-2: hydroxyethyl methacrylate

Other polymerizable unsaturated monomers:
e-1: n-butyl methacrylate
e-2: n-butyl acrylate
e-3: 2-ethylhexyl acrylate
e-4: methyl methacrylate
e-5: ethyl acrylate
e-6: methacrylic acid
e-7: itaconic acid
e-8: p-toluenesulfonic acid

### Example 20

A back sheet for a solar battery was prepared in the same manner as in Example 10, except that in the gas barriering film prepared in Example 10, used were three inorganic thin film layers obtained by applying 1 kW under vacuum of 8 × 10⁻² Torr with a 13.56 MHz high frequency discharge plasma source using tetraethoxysilane as a raw material and oxygen, nitrogen and argon as reaction gases by means of a plasma CVD equipment to form a plasma CVD film having a film thickness of 20 µm comprising SiOₓN_{y} (x = 1.6, y = 0.2) on a surface of the inorganic thin film and further forming a vacuum vapor deposition film on a surface of the above plasma CVD film by the same method as in Example 1.

### Example 21

A back sheet for a solar battery was prepared in the same manner, except that in Example 10, three gas barriering films were stuck and laminated respectively on an inorganic thin film side and a plastic film side, and then it was laminated on the polyethylene naphthalate film used in Example 1.

### Example 22

Aback sheet for a solar battery was prepared in the same manner, except that in Example 6, a biaxially stretched polyethylene naphthalate film ("Q51C12" manufactured by Teijin DuPont Films Japan Ltd.) having a thickness of 12 µm was used as the base material film for the gas barriering film, and a weather resistant coating layer was formed on a corona-treated surface thereof.

### Example 23

A back sheet for a solar battery was prepared in the same manner, except that in Example 10, a coextruded biaxially stretched film of a polyethylene naphthalate resin obtained by the following method and a polyethylene terephtalate resin was used as the base material film for the gas barriering film to form a weather resistant coating layer on a corona-treated surface thereof.
A reactor was charged with 100 parts of dimethyl naphthalene-2,6-dicarboxylate, 60 parts of ethylene glycol and 0.1 part of magnesium acetate tetrahydrate and heated from a reaction initiating temperature of 180°C up to 230°C in 4 hours to carry out transesterification, and 0.2 part of amorphous silica having an average particle diameter of 2.5 µm was added thereto in the form of a slurry of ethylene glycol. Next, 0.04 part of phosphoric acid and 0.04 part of antimony trioxide were added thereto, and then polycondensation reaction was carried out by an ordinary method. Thus, polyethylene naphthalate having an intrinsic viscosity of 0.58 was obtained. Chips were prepared from the above product and subjected to solid phase polymerization at 235°C under reduced pressure to obtain a polyethylene naphthalate resin having an intrinsic viscosity of 0.68.
Next, the polyethylene naphthalate resin described above and a polyethylene terephthalate resin (Novapecs, manufactured by Mitsubishi Chemical Corporation) were extruded on a cast roll by a coextrusion method to obtain a formless sheet. Subsequently, it was stretched in a 3.0 times ratio in a longitudinal direction and then in a 3.5 times ratio in a lateral direction and thermally fixed to prepare a coextruded biaxially stretched film having a thickness ratio polyethylene naphthalate : polyethylene terephthalate of 1 : 3 and a total thickness of 12 µm, and a polyethylene naphthalate surface side was subjected to corona treatment.

### Example 24

Aback sheet for a solar battery was prepared in the same manner, except that in Example 10, the coextruded biaxially stretched polyethylene naphthalate film ("Q51C12" manufactured by Teijin DuPont Films Japan Ltd.) having a thickness of 12 µm was used as the base material film for the gas barriering film to form a weather resistant coating layer on a corona-treated surface, whereby a gas barriering film was obtained, and a biaxially stretched film having a thickness of 50 µm which comprises a polyethylene terephthalate resin having a number average molecular weight of 25,000 and has a heat shrinkage rate of 0.9 % on the conditions of 150°C and 30 minutes was used for the weather resistant polyester base resin layer.

### Example 25

A back sheet for a solar battery was prepared in the same manner, except that in Example 10, the biaxially stretched polyethylene naphthalate film ("Q51C12" manufactured by Teijin DuPont Films Japan Ltd.) having a thickness of 12 µm was used as the base material film for the gas barriering film.

### Example 26

A back sheet for a solar battery was prepared in the same manner, except that in Example 25, the respective films were laminated without providing the readily-adhesive coat on the light shielding colored (white) film, and then a linear low density polyethylene film ("T.U.X HC" manufacture by Tohcello Co., Ltd.) having a thickness of 50 µm was stuck as a readily-adhesive layer on a corona-treated surface of the light shielding colored (white) film.

### Example 27

The light shielding colored (white) film prepared in Example 1 was used as the base material film for the gas barriering film, and a weather resistant coating layer and a thin film were provided on a surface side reverse to the readily-adhesive layer in the same manner as in Example 10 to obtain the gas barriering film, whereby the film comprising the light shielding colored layer, and the gas barriering layer containing the weather resistant coating layer and the inorganic thin film layer was prepared. Then, the polyethylene naphthalate film used in Example 1 in which 10 g/m² of the adhesive was coated on a corona-treated surface was stuck on an inorganic thin film surface side of the above gas barriering layer and laminated to prepare a back sheet for a solar battery.

### Example 28

A biaxially stretched polyethylene naphthalate film ("Q65F100" manufactured by Teijin DuPont Films Japan Ltd.) having a thickness of 100 µm was used as the base material film for the gas barriering film and subjected to corona treatment, and a weather resistant coating layer was formed on the above corona-treated surface to obtain a gas barriering film in the same manner as in Example 6, whereby a film comprising the gas barriering layer containing the weather resistant coating layer and the inorganic thin film layer and the weather resistant polyester base resin layer was prepared. Then, the light shielding colored (white) film prepared in Example 1 in which 10 g/m² of the adhesive was coated on a surface side reverse to the readily-adhesive layer was stuck on an inorganic thin mm surface side of the above gas barriering layer and laminated to prepare a back sheet for a solar battery.

### Example 29

A back sheet for a solar battery was prepared in the same manner as in Example 6, except that precipitated calcium carbonate ("Vigot-10" manufactured by Shiraishi Kogyo Kaisha, Ltd.) was used as a white pigment for the light shielding colored (white) film to obtain a white film.

### Example 30

Aback sheet for a solar battery was prepared in the same manner as in Example 21, except that carbon black ("#650B" manufactured by Mitsubishi Chemical Corporation) was used in place of the white pigment in the light shielding colored (black) film prepared in Example 1 to prepare a light shielding colored (black) film containing 5 % by mass of carbon black.

### Example 31

A film comprising a gas barriering layer and a weather resistant polyester base resin layer was prepared in the same manner, except that in Example 28, the coating liquid prepared in Example 10 was used for the weather resistant coating layer. Then, the light shielding colored (black) film prepared in Example 30 in which 10 g/m² of the adhesive was coated on a surface side reverse to the readily-adhesive layer was stuck on an inorganic thin film surface side of the above gas barriering layer and laminated to prepare a back sheet for a solar battery.

### Example 32

A back sheet for a solar battery was prepared in the same manner, except that in Example 31, the respective films were laminated without providing the readily-adhesive coat on the light shielding colored (black) film, and then a polypropylene film ("PYLEN FILM-CT" manufactured by Toyobo Co., Ltd.) having a thickness of 100 µm was stuck as a readily-adhesive layer on a corona-treated surface of the light shielding colored (black) film.

### Comparative Example 1

A gas barriering film was obtained in the same manner as in Example 1 to prepare a back sheet for a solar battery, except that the weather resistant coating layer was not formed on the gas barriering film.

### Comparative Example 2

A gas barriering film was obtained in the same manner as in Example 1 to prepare a back sheet for a solar battery, except that the coating liquid for the gas barriering film was changed to the following one.

### Coating liquid:

Saturate polyester ("VYLON 300" manufactured by Toyobo Co., Ltd.) and an isocyanate compound ("Coronate L" manufactured by Nippon Polyurethane Industry Co., Ltd.) were mixed in a mass ratio of 1:1 to prepare a coating liquid.

### Comparative Example 3

A gas barriering films was obtained in the same manner as in Example 1 to prepare a back sheet for a solar battery except that the coating liquid for the gas barriering film was changed to the following one.

### Coating liquid:

An acryl base copolymer ("Takelac UA-902" manufactured by Mitsui Chemicals Polyurethane, Inc.) and aromatic isocyanate (tolylenediisocyanate (TDI), "Cosmonate 80" manufactured by Mitsui Chemicals Polyurethane, Inc.) were mixed so that an equivalent proportion of an isocyanate group value to a hydroxy group value was 1:1 to prepare a coating liquid.

The respective back sheets obtained in the examples and the comparative examples described above were evaluated for a whiteness degree, an adhesive property (peeling test) of the constitutional layers after stored at 85°C and 85 RH % for 1000 hours and 3000 hours, a water vapor transmission rate (WTR) and an ERA adhesive property, and the results thereof are shown in Table 2.

**Table 2.1**

| | Readily-adhesive layer | Light shielding colored film | | | Gas barriering film | | | | | Weather resistant polyester base resin film | |
|---|---|---|---|---|---|---|---|---|---|---|---|
| | | Substrate film | Pigment | Thick-Ness (µm) | Substrate film | Thick-Ness (µm) | Weather resistant coat | Inorganic thin film | Laminate | Substrate film | Thickness (µm) |
| Example 1 | coat | PBT | Barium sulfate- | 150 | PET | 12 | Polycaprolactone-diols + epoxy | Siox | 1 film | PEN | 50 |
| Example 2 | coat | PET | Barium sulfate | 150 | PET | 12 | polycaprolactone-polyol + isocyanate | SiOx | 1 film | PEN | 50 |
| Example 3 | coat | PET | Barium sulfate | 150 | PET | 12 | Polycarbonate-diol + isocyanate | SiOx | 1 film | PEN | 50 |
| Example 4 | coat | PET | Barium sulfate | 150 | PET | 12 | Polycarbonate diol + isocyanate | SiOx | 1 film | PEN | 50 |
| Example 5 | coat | PET | Barium sulfate | 150 | PET | 12 | Polyvinylbutyral + epoxy | SiOx | 1 film | PEN | 50 |
| Example 6 | coat | PET | Barium sulfate | 150 | PET | 12 | Polyvinylbutyral + isocyanate | SiOx | 1 film | PEN | 50 |
| Example 7 | coat | PET | Barium sulfate | 150 | PET | 12 | Polyacetacetal + isocyanate | SiOx | 1 film | PEN | 50 |
| Example 8 | coat | PET | Barium sulfate | 150 | PET | 12 | Acryl copolymer + epoxy | SiOx | 1 film | PEN | 50 |
| Example 9 | coat | PET | Barium sulfate | 150 | PET | 12 | Acryl copolymer + isocyanate | SiOx | 1 film | PEN | 50 |
| Example 10 | coast | PET | Barium sulfate | 150 | PET | 12 | Acryl copolymer + isocyanate | SiOx | 1 film | PEN | 50 |
| Example 11 | coat | PET | Barium sulfate | 150 | PET | 12 | Acryl copolymer + isocyanate | SiOx | 1 film | PEN | 50 |
| Example 12 | coat | PET | Barium sulfate | 150 | PET | 12 | Acryl copolymer + isocyanate | SiOx | 1 film, | PEN | 50 |
| Example 13 | coat | PET | Barium sulfate | 150 | PET | 12 | Acryl copolymer + isocyanate | SiOx | 1 film | PEN | 50 |
| Example 14 | coat | PET | Barium sulfate | 150 | PET | 12 | Acryl copolymer + isocyanate | SiOx | 1 film | PEN | 50 |
| Example 15 | coat | PET | Barium sulfate | 150 | PET | 12 | Acryl copolymer + isocyanate | SiOx | 1 film | PEN | 50 |
| Example 16 | coat | PET | Barium sulfate | 150 | PET | 12 | Acrylc opolymer + isocyanate | SiOx | 1 film | PEN | 50 |
| Example 17 | coat | PET | Barium sulfate | 150 | PET | 12 | Acryl copolymer + isocyanate | SiOx | 1 film | PEN | 50 |
| Example 18 | coat | PET | Barium sulfate | 150 | PET | 12 | Acryl copolymer + isocyanate | SiOx | 1 film | PEN | 50 |

**Table 2-2**

| | Readily-adhesive layer | Light shielding colored film | | | Gas barriering film | | | | | Heather resistant polyester base resin film | |
|---|---|---|---|---|---|---|---|---|---|---|---|
| | | Substrate film | Pigment | Thickness (µm) | Thick strate film | Thickness (µm) | Weather resistant coat | Inorganic thin film | Laminate | substrate film | Thickness (µm) |
| Example 19 | coat | PET | Barium sulfate | 150 | PET | 12 | Acryl copolymer | SiOx | 1 film | PEN | 50 |
| Example 20 | coat | PET | Barium sulfate | 150 | PET | 12 | Acryl-copolymer + isocyanate | SiOx/Siox/ Siox | 1 film | PEN | 50 |
| Example 21 | coat | PET | Barium sulfate | 150 | PET | 12 | Acryl copolymer + isocyanate | SiOx | 3 films | PEN | 50 |
| Example 22 | coat | PET | Barium sulfate | 150 | PEN | 12 | Polyvinylbutyral + isocyanate | SiOx | 1 film | PEN | 50 |
| Example 23 | coat | PET | Barium sulfate | 150 | PEN/ PET | 12 | Acryl copolymer + isoyanate | SiOx | 1 film | PEN | 50 |
| Example 24 | coat | PET | Barium sulfate | 150 | PET | 12 | Acryl copolymer + isocyanate | SiOx | 1 film | PET | 50 |
| Example 25 | coat | PET | Barium sulfate | 150 | PEN | 12 | Acryl copolymer + isocyanate | SiOx | 1 film | PEN | 50 |
| Example 26 | *PE film* | PET | Barium sulfate | 150 | PEN | 12 | Acryl copolymer +isocyanate | SiOx | 1 film | PEN | 50 |
| Example 27 | coat | PET | Barium sulfate | 150 | double with colored film | | Acryl copolymer + isocyanate | SiOx | 1 film | PEN | 50 |
| Example 28 | coat | PET | Barium sulfate | 150 | double with weather resistant film | | Polyvinylbutyral + isocyanate | SiOx | 1 film | PEN | 100 |
| Example 29 | coat | PET | Calcium carbonate | 150 | PET | 12 | Polyvinylbutyral + isocyanate | SiOx | 1 film | PEN | 50 |
| Example 30 | coat | PET | Carbon black | 150 | PET | 12 | Acryl copolymer + isocyanate | SiOx | 3 films | PEN | 50 |
| Example 31 | coat | PET | Carbon black | 150 | double with weather resistant film | | Acryl copolymer + isocyanate | SiOx | 1 film | PEN | 100 |
| Example 32 | PP film | PET | Carbon black | 100 | double with weather resistant film | | Acryl copolymer + isocyanate | SiOx | 1 film | PEN | 100 |
| Comparative Example 1 | coat | PET | Barium sulfate | 150 | PET | 12 | None | SiOx | 1 film | PEN | 50 |
| Comparative Example 2 | coat | PET | Barium sulfate | 150 | PET | 12 | Polyesterpolyol + isocyanate | SiOx | 1 film | PEN | 50 |
| Comparative Example 3 | coat | PET | Barium sulfate | 150 | PET | 12 | Acrylpolyol + isocyanate | SiOx | 1 film | PEN | 50 |

**Table 2-3**

| | Back sheet | Back sheet after 85°C, 85 RH%, 1000 hours | | | Back sheet after 85°C 85 RH %, 3000 hours | | |
|---|---|---|---|---|---|---|---|
| | Whiteness degree | Peeling test | WTR (g/m²/day) | EVA adhesive property | Peeling test | WTR (g/m²/day) | EVA adhesive property |
| Example 1 | 85 % | O | 0.6 | O | O | 0.9 | O |
| Example 2 | 85 % | O | 0.6 | O | O | 0.9 | O |
| Example 3 | 85 % | O | 0.6 | O | O | 0.9 | O |
| Example 4 | 85 % | O | 0.6 | O | O | 0.9 | O |
| Example 5 | 85 % | O | 0.5 | O | O | 0.7 | O |
| Example 6 | 85 % | O | 0.5 | O | O | 0.7 | O |
| Example 7 | 85 % | O | 0.5 | O | O | 0.7 | O |
| Example 8 | 85 % | O | 0.5 | O | O | 0.7 | O |
| Example 9 | 85 % | O | 0.3 | O | O | 0.5 | O |
| Example 10 | 85 % | O | 0.3 | O | O | 0.5 | O |
| Example 11 | 85 % | O | 0.3 | O | O | 0.5 | O |
| Example 12 | 85 % | O | 0.3 | O | O | 0.5 | O |
| Example 13 | 85 % | O | 0.3 | O | O | 0.5 | O |
| Example 14 | 85 % | O | 0.3 | O | O | 0.5 | O |
| Example 15 | 85% | O | 0.3 | O | O | 0.5 | O |
| Example 16 | 85% | O | 0.3 | O | O | 0.5 | O |
| Example 17 | 85% | O | 0.3 | O | O | 0.5 | O |
| Example 18 | 85 % | O | 0.3 | O | O | 0.5 | O |

**Table 2-4**

| | Back sheet | Back sheet after 85°C, 85 RH %, 1000 hours | | | Back sheet after 85°C, 85 RH %, 3000 hours | | |
|---|---|---|---|---|---|---|---|
| | Whiteness degree | Peeling test | WTR (g/m²/day) | EVA adhesive property | Peeling test | WTR (g/m²/day) | EVA adhesive property |
| Example 19 | 85% | O | 0.6 | O | O | 0.9 | O |
| Example 20 | 85% | O | 0.2 | O | O | 0.3 | O |
| Example 21 | 85 % | O | <0.1 | O | O | <0.1 | O |
| Example 22 | 85% | O | 0.2 | O | O | 0.3 | O |
| Example 23 | 85 % | O | 0.2 | O | O | 0.3 | O |
| Example 24 | 85 % | O | 0.4 | O | O | 0.6 | O |
| Example 25 | 85 % | O | <0.1 | O | O | <0.1 | O |
| Example 26 | 85 % | O | <0.1 | Ⓞ | O | <0.1 | Ⓞ |
| Example 27 | 85% | O | 0.4 | O | O | 0.6 | O |
| Example 28 | 85 % | O | 0.2 | O | O | 0.3 | O |
| Example 29 | 75 % | O | 0.7 | O | O | 0.9 | O |
| Example 30 | - | O | <0.1 | O | O | <0.1 | O |
| Example 31 | - | O | <0.1 | O | O | <0.1 | O |
| Example 32 | - | O | <0.1 | Ⓞ | O | <0.1 | Ⓞ |
| Comparative Example 1 | 85% | X | >50 | O | X | >50 | O |
| Comparative Example 2 | 85 % | X | >50 | ○ | X | >50 | O |
| Comparative Example 3 | 85 % | X | >10 | O | X | >50 | ○ |

### INDUSTRIAL APPLICABILITY

The back sheet for a solar battery according to the present invention is excellent in a gas barriering property, a weatherability and a light shielding property in use for long time, and therefore it can suitably be used as a back sheet corresponding to various modules for solar batteries of a monocrystalline silicon base, an amorphous silicon base, a thin film crystal base, a compound semiconductor base, an organic thin film base, a dye sensitizing base and the like.

## Claims

1. Aback sheet for a solar battery comprising a light shielding colored layer and a weather resistant polyester base resin layer and comprising a gas barriering layer containing a weather resistant coating layer and an inorganic thin film layer provided between the above layers, wherein the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

2. The back sheet for a solar battery according to claim 1, wherein the light shielding colored layer comprises a polyester base resin.

3. The back sheet for a solar battery according to claim 1 or 2, wherein the cross-linked product (a) of polycaprolactonepolyol and/or polycarbonatepolyol is obtained by cross-linking polycaprolactonepolyol and/or polycarbonatepolyol with an isocyanate compound and/or an epoxy compound.

4. The back sheet for a solar battery according to any of claims 1 to 3, wherein the modified polyvinyl alcohol of (b) is polyvinylbutyral and/or polyvinylacetal.

5. The back sheet for a solar battery according to any of claims 1 to 4, wherein the acryl base copolymer (c) having at least one group selected from the group consisting of a UV ray stabilizing group, a UV ray absorbing group and a cycloalkyl group is obtained by reacting an acryl base copolymer having at least one group selected from the group consisting of a hindered amine group, a benzotriazole group and/or a benzophenone group and a cycloalkyl group and a hydroxyl group with an isocyanate compound and/or an epoxy compound.

6. The back sheet for a solar battery according to any of claims 1 to 5, comprising two or more gas barriering layers containing a weather resistant coating layer and an inorganic thin film layer.

7. The back sheet for a solar battery according to any of claims 1 to 6, wherein the light shielding colored layer comprises a white film or a black film.

8. The back sheet for a solar battery according to claim 7, wherein the light shielding colored layer contains barium sulfate.

9. The back sheet for a solar battery according to any of claims 1 to 8, comprising a readily-adhesive layer provided on an outside surface of the light shielding colored layer.

10. The back sheet for a solar battery according to claim 9, wherein the readily-adhesive layer comprises a polyolefin base resin.

11. The back sheet for a solar battery according to any of claims 1 to 10, wherein the light shielding colored layer has a light transmission factor of 1.0 %or less in a wavelength of 350 nm.

12. The back sheet for a solar battery according to any of claims 1 to 11, wherein the gas barriering layer contains a polyester base resin.

13. The back sheet for a solar battery according to any of claims 1 to 12, wherein the gas barriering layer contains a polyethylene naphthalate resin.

14. The back sheet for a solar battery according to any of claims 1 to 13, wherein the weather resistant polyester base resin layer has a strength holding rate of 50 % or more after 3000 hours at 85°C and 85 RH %.

15. The back sheet for a solar battery according to any of claims 1 to 14, wherein other films are further provided between any layers of the light shielding colored layer, the gas barriering layer and the weather resistant polyester base resin layer.

16. The back sheet for a solar battery according to any of claims 1 to 15, comprising a film comprising the light shielding colored layer and a film comprising the weather resistant polyester base resin layer and comprising a film comprising the gas barriering layer containing the weather resistant coating layer and the inorganic thin film layer provided between the above films.

17. The back sheet for a solar battery according to any of claims 1 to 15, comprising (1) a film comprising the light shielding colored layer and the gas barriering layer containing the weather resistant coating layer and the inorganic thin film layer and (2) a film comprising the weather resistant polyester base resin layer.

18. The back sheet for a solar battery according to any of claims 1 to 15, comprising (1) a film comprising the light shielding colored layer and (2) a film comprising the gas barriering layer containing the weather resistant coating layer and the inorganic thin film layer and the weather resistant polyester base resin layer.

19. A solar battery module comprising the back sheet for a solar battery according to any of claims 1 to 18.
